# EUROPÄISCHE PATENTANMELDUNG

(11) **EP 4 845 011 A1**
(43) Veröffentlichungstag der Anmeldung: **25.11.2026**
(21) Anmeldenummer: 25177715.7
(22) Anmeldetag: 20.05.2025
(51) Int. Cl.: H02M 3/335, H02M 1/08, H02M 1/32, H02M 1/00, H02M 3/00, H02M 7/00, H03K 17/605, H03K 17/61, H03K 17/689, H03K 17/691, H01L 25/07, B23K 9/10

(54) **VORRICHTUNG ZUR ERZEUGUNG EINES SCHWEISSSTROMS FÜR EIN SCHWEISSGERÄT MIT INTEGRIERTEM LEISTUNGSELEKTRONIK-MODUL SOWIE SCHWEISSGERÄT**

(71) Anmelder: EWM GmbH, 56271 Mündersbach (DE)
(72) Erfinder: SIEGERT, Levin, 57648 Unnau (DE); GIEBL, Stefan, 65618 Selters (Taunus) - Münster (DE)
(74) Vertreter: Cohausz & Florack

(57) **Zusammenfassung**

Die Erfindung betrifft eine Vorrichtung (350, 350') zur Erzeugung eines Schweißstroms für ein Schweißgerät (100), insbesondere Lichtbogenschweißgerät, mit einer Leistungshalbleiter-Schaltung (206) umfassend ein oder mehrere Leistungshalbleiter-Schaltelemente (S1, S2, S3, S4) und mit einer Gate-Treiber-Schaltung (208), die ein oder mehrere Steuersignaleingänge (T1, T2, T3, T4) zum Empfang von elektrischen Steuersignalen und ein oder mehrere Treiberausgänge (TA1, TA2, TA3, TA4) zum elektrischen Ansteuern der ein oder mehreren Leistungshalbleiter-Schaltelemente (S1, S2, S3, S4) aufweist und dazu eingerichtet ist, die Leistungshalbleiter-Schaltelemente (S1, S2, S3, S4) abhängig von über die ein oder mehreren Steuersignaleingänge (T1, T2, T3, T4) empfangenen elektrischen Steuersignalen elektrisch anzusteuern, wobei die Gate-Treiber-Schaltung (208) so ausgebildet ist, dass die ein oder mehreren Steuersignaleingänge (T1, T2, T3, T4) von den ein oder mehreren Treiberausgängen (TA1, TA2, TA3, TA4) galvanisch getrennt sind, und wobei die Vorrichtung (350, 350') ein integriertes Leistungselektronik-Modul (300, 300') aufweist, das sowohl die Leistungshalbleiter-Schaltung (206) als auch die Gate-Treiber-Schaltung (208) umfasst. Die Erfindung betrifft weiter ein Schweißgerät (100), insbesondere Lichtbogenschweißgerät, aufweisend eine solche Vorrichtung (350, 350').

## Beschreibung

Die vorliegende Erfindung betrifft eine Vorrichtung zur Erzeugung eines Schweißstroms für ein Schweißgerät, insbesondere Lichtbogenschweißgerät, mit einer Leistungshalbleiter-Schaltung umfassend ein oder mehrere Leistungshalbleiter-Schaltelemente und mit einer Gate-Treiber-Schaltung, die ein oder mehrere Steuersignaleingänge zum Empfang von elektrischen Steuersignalen und ein oder mehrere Treiberausgänge zum elektrischen Ansteuern der ein oder mehreren Leistungshalbleiter-Schaltelemente aufweist und dazu eingerichtet ist, die Leistungshalbleiter-Schaltelemente abhängig von über die ein oder mehreren Steuersignaleingänge empfangenen elektrischen Steuersignalen elektrisch anzusteuern, wobei die Gate-Treiber-Schaltung so ausgebildet ist, dass die ein oder mehreren Steuersignaleingänge von den ein oder mehreren Treiberausgängen galvanisch getrennt sind. Die vorliegende Erfindung betrifft weiter ein Schweißgerät, insbesondere Lichtbogenschweißgerät, mit einer solchen Vorrichtung.

Aus dem Stand der Technik sind Lichtbogenschweißstromquellen mit Hochleistungs-Schaltnetzteilen (sog. Inverter) bekannt, in denen Silizium-Halbleiterschalter, insbesondere Si-IGBTs oder Si-MOSFETs, eingesetzt werden. Auf diese Weise lässt sich zwar ein höherer Wirkungsgrad gegenüber Schweißstromquellen mit auf Netzfrequenz arbeitenden Transformatoren erreichen und Baugröße sowie Gewicht reduzieren. Jedoch kommt es weiterhin zu signifikanten Verlusten durch die Verwendung von Silizium-Halbleiterschaltern, speziell wegen deren Schaltverlusten aufgrund vergleichsweise geringer Schaltgeschwindigkeit. Diese Verluste erhöhen den Energieverbrauch und werden in Form von Wärme abgegeben, welche durch Kühlkörper oder vergleichbare Vorrichtungen an die Umgebung abgegeben werden müssen.

Kommerziell erhältliche Siliziumcarbid(SiC)-Leistungshalbleiter oder -module im geeigneten Leistungsbereich sind aufgrund ihrer höheren maximalen Schaltgeschwindigkeit prinzipiell in der Lage, die primärseitigen Schaltverluste von Schweißstromquellen zu reduzieren und den Wirkungsgrad des Inverters zu erhöhen. Die Integration solcher Module in Schweißgeräte bringt jedoch neue Herausforderungen mit sich.

So ist eine aus Sicherheitsgesichtspunkten besonders kritische Komponente von Schaltnetzteilen die Isolierung der Ansteuertreiberstufe zur Übertragung der Gate-Ansteuerimpulse vom Steuerstromkreis, der in der Regel auf Sicherheitskleinspannungs-Potential (SELV-Stromkreis) liegt, über die galvanische Trennung hinweg zu den Leistungstransistoren, die sich im Versorgungs-Stromkreis auf Primär-Potential befinden. Die galvanische Trennung wird daher mit doppelter oder verstärkter Isolierung ausgeführt.

Gängige Lösungsansätze wie Ansteuerübertrager kommen jedoch bei SiC-Leistungshalbleitern an ihre Grenzen, da SiC-Leistungshalbleiter zum einen hohe Anforderungen an die Genauigkeit der Ansteuerpegel stellen und zum anderen die für die gewünschten steilen Schaltflanken erforderlichen Spitzen-Ströme zur schnellen Umladung der Gate-Eingangskapazitäten nicht mehr mit der erforderlichen Steilheit über die galvanische Trennung hinweg übertragen werden können. Dies hat zur Folge, dass mit solchen Ansteuer-Übertragern keine hohen Schaltgeschwindigkeiten erreicht und die Schaltverluste nicht deutlich reduziert werden können.

Weiter besteht bei Schweißgeräten - anders als bei fast allen anderen elektrischen Betriebsmitteln mit einem Schaltnetzteil - die Anforderung, dass Schweißgeräte gemäß der Produktnorm IEC 60974-1 so ausgelegt werden müssen, dass sie auch in einer Umgebung mit Verschmutzungsgrad 3 sicher betrieben werden können. Dadurch ergeben sich höhere Anforderungen an Luft- und Kriechstrecken. Größere Isolations-Abstände vergrößern jedoch die mechanischen Abmessungen des Aufbaus und damit die Schleifenimpedanzen des Gate-Ansteuerstromkreises und der Kommutierungskreise im Leistungs-Stromkreis. Dies läuft jedoch den immer größer werdenden Anforderungen an steile Schaltflanken für Wide-Bandgap-Leistungshalbleiter zuwider.

Vor diesem Hintergrund liegt der vorliegenden Erfindung die Aufgabe zu Grunde, eine Vorrichtung zur Erzeugung eines Schweißstroms für ein Schweißgerät, insbesondere Lichtbogenschweißgerät, zur Verfügung zu stellen, die einen sichereren, ökonomischeren und/oder verlustärmeren Betrieb ermöglicht. Weiter liegt der vorliegenden Erfindung die Aufgabe zu Grunde, ein Schweißgerät, insbesondere Lichtbogenschweißgerät, mit einer solchen Vorrichtung zur Verfügung zu stellen.

Die zuvor genannte Aufgabe wird erfindungsgemäß gelöst durch eine Vorrichtung zur Erzeugung eines Schweißstroms für ein Schweißgerät, insbesondere Lichtbogenschweißgerät, mit einer Leistungshalbleiter-Schaltung umfassend ein oder mehrere Leistungshalbleiter-Schaltelemente und mit einer Gate-Treiber-Schaltung, die ein oder mehrere Steuersignaleingänge zum Empfang von elektrischen Steuersignalen und ein oder mehrere Treiberausgänge zum elektrischen Ansteuern der ein oder mehreren Leistungshalbleiter-Schaltelemente aufweist und dazu eingerichtet ist, die Leistungshalbleiter-Schaltelemente abhängig von über die ein oder mehreren Steuersignaleingänge empfangenen elektrischen Steuersignalen elektrisch anzusteuern, wobei die Gate-Treiber-Schaltung so ausgebildet ist, dass die ein oder mehreren Steuersignaleingänge von den ein oder mehreren Treiberausgängen galvanisch getrennt sind, und wobei die Vorrichtung ein integriertes Leistungselektronik-Modul aufweist, das sowohl die Leistungshalbleiter-Schaltung als auch die Gate-Treiber-Schaltung umfasst.

Durch die Integration der Leistungshalbleiter-Schaltung und der Gate-Treiber-Schaltung in ein integriertes Leistungselektronik-Modul können die normativen Anforderungen an die sichere elektrische Trennung, insbesondere für Verschmutzungsgrad 3, einfacher erfüllt werden. Dies ist insbesondere deshalb vorteilhaft, da die gängigen, im Handel verfügbaren Bauelemente lediglich kleinere Kriechstrecken aufweisen, die - wenn überhaupt - nur den Anforderungen für Verschmutzungsgrad 2 genügen. Mit dem integrierten Leistungselektronik-Modul lassen sich auch bei Verwendung solcher Bauelemente die Anforderungen für Verschmutzungsgrad 3 erfüllen.

Darüber hinaus kann durch die kompakte Unterbringung der Leistungshalbleiter-Schaltung mit den Leistungshalbleiter-Schaltelementen und der Gate-Treiber-Schaltung in einem integrierten Leistungselektronik-Modul die Schleifeninduktivität der Gate-Ansteuerstromkreise reduziert werden, wodurch eine in Pegel und Schaltflanke möglichst präzise Ansteuerung der Leistungshalbleiter-Schaltelemente und/oder höhere Taktfrequenzen ermöglicht werden.

Die Vorrichtung weist eine Leistungshalbleiter-Schaltung mit ein oder mehreren Leistungshalbleiter-Schaltelementen auf. Die Leistungshalbleiter-Schaltung kann beispielsweise eine Vollbrückenwandler-Schaltung, Halbbrückenwandler-Schaltung, Sperrwandler-Schaltung, Durchflusswandler-Schaltung und/oder LLC-WandlerSchaltung umfassen.

Ein für die Leistungshalbleiter-Schaltung verwendetes Leistungshalbleiter-Schaltelement kann insbesondere einen Transistor, vorzugsweise einen Feldeffekttransistor, wie zum Beispiel MOSFET, JFET oder HEMT, einen Bipolartransistor oder einen IGBT, umfassen. Das Leistungshalbleiter-Schaltelement kann weiter eine antiparallel zum Transistor geschaltete Diode aufweisen.

Ein oder mehrere der für die Leistungshalbleiter-Schaltung verwendeten Leistungshalbleiter-Schaltelemente können auch mehrere, insbesondere parallel und/oder in Reihe geschaltete, Transistoren umfassen. Die parallel und/oder in Reihe geschalteten Transistoren können Bipolartransistoren, Feldeffekttransistoren und/oder IGBTs umfassen, unabhängig von deren Halbleitermaterialien. Beispielsweise kann ein solches Leistungshalbleiter-Schaltelement eine Kaskodenschaltung mit zwei oder mehreren Transistoren umfassen. Weiterhin kann ein solches Leistungshalbleiter-Schaltelement einen emittergeschalteten Bipolartransistor (ESBT: emitter switched bipolar transistor), d.h. einen Bipolartransistor in Kombination mit einem MOSFET, umfassen.

Die Vorrichtung weist weiter eine Gate-Treiber-Schaltung auf.

Der Begriff Gate, wie in Gate-Treiber-Schaltung, wird vorliegend ungeachtet der Art der tatsächlich in den Leistungshalbleiter-Schaltelementen verwendeten Transistoren verwendet. So kann unter Gate vorliegend sowohl der Gate-Anschluss eines Feldeffekttransistors, zum Beispiel eines MOSFET, JFET, oder eines IGBTs als auch der Basis-Anschluss eines Bipolartransistors verstanden werden.

Die Gate-Treiber-Schaltung dient zur Ansteuerung der ein oder mehreren Leistungshalbleiter-Schaltelemente der Leistungshalbleiter-Schaltung. Zu diesem Zweck weist die Gate-Treiber-Schaltung ein oder mehrere Steuersignaleingänge zum Empfang von elektrischen Steuersignalen auf.

Die ein oder mehreren Steuersignaleingänge sind vorzugsweise zum Anschließen ein oder mehrerer Steuersignalleitungen, insbesondere einer jeweiligen Steuersignalleitung, ausgebildet. Zu diesem Zweck können beispielsweise ein oder mehrere mechanische Verbinderteile, wie Steckverbinderteile, zum mechanischen und elektrischen Verbinden mit den Steuersignalleitungen, beispielsweise über korrespondierende Verbinderteile, vorgesehen sein. Es ist auch denkbar, dass die ein oder mehreren Steuersignaleingänge fest mit einer jeweiligen Steuersignalleitung verbunden, beispielsweise verlötet, werden können oder verlötet sind. Zu diesem Zweck kann für die einzelnen Steuersignaleingänge beispielsweise eine jeweilige Lötfahne vorgesehen sein.

Es kann insbesondere für jedes der von der Gate-Treiber-Schaltung angesteuerten Leistungshalbleiter-Schaltelemente ein jeweiliger Steuersignaleingang vorgesehen sein. Die Steuersignalleitungen können beispielsweise in ein oder mehreren mehradrigen Kabeln untergebracht sein und die ein oder mehreren Steuersignaleingänge können insbesondere zum Anschließen von ein oder mehreren mehradrigen Kabeln ausgebildet sein.

Beispielsweise kann die Vorrichtung eine Steuerelektronik aufweisen, die die Steuersignale zur Steuerung der Leistungshalbleiter-Schaltung erzeugt und die zur Übermittelung der Steuersignale mit den ein oder mehreren Steuersignaleingängen verbunden ist. Die Steuerelektronik kann insbesondere mindestens einen Mikroprozessor, vorzugsweise einen Mikrocontroller, umfassen. Die Steuerelektronik ist insbesondere dazu eingerichtet, Steuersignale an die ein oder mehreren Steuersignaleingänge zu übermitteln.

Die Gate-Treiber-Schaltung weist weiter ein oder mehrere Treiberausgänge zum elektrischen Ansteuern der ein oder mehreren Leistungshalbleiter-Schaltelemente auf. Insbesondere kann je Leistungshalbleiter-Schaltelement ein jeweiliger Treiberausgang vorgesehen sein, der mit einem Gate-Anschluss eines jeweiligen der Leistungshalbleiter-Schaltelemente elektrisch leitend verbunden ist. Weiter kann insbesondere je Treiberausgang mindestens ein Steuersignaleingang vorgesehen sein.

Die Gate-Treiber-Schaltung ist dazu eingerichtet, die Leistungshalbleiter-Schaltelemente abhängig von über die ein oder mehreren Steuersignaleingänge empfangenen elektrischen Steuersignalen elektrisch anzusteuern. Ist beispielsweise für jedes der von der Gate-Treiber-Schaltung angesteuerten Leistungshalbleiter-Schaltelemente ein jeweiliger Steuersignaleingang vorgesehen, so kann die Gate-Treiber-Schaltung beispielsweise dazu eingerichtet sein, die einzelnen Leistungshalbleiter-Schaltelemente über die ein oder mehreren Treiberausgänge, insbesondere über einen jeweiligen der Treiberausgänge, entsprechend der über den dem jeweiligen Leistungshalbleiter-Schaltelement zugeordneten Steuersignaleingang empfangenen Steuersignale anzusteuern.

Die Gate-Treiber-Schaltung kann insbesondere ein oder mehrere Gate-Treiber aufweisen, die jeweils dazu eingerichtet sind, die Ansteuerung von mindestens einem der ein oder mehreren Leistungshalbleiter-Schaltelemente über einen der Treiberausgänge abhängig von über mindestens einen der ein oder mehreren Steuersignaleingänge erhaltenen Steuersignalen zu bewirken.

Die Gate-Treiber-Schaltung ist so ausgebildet, dass die ein oder mehreren Steuersignaleingänge von den ein oder mehreren Treiberausgängen galvanisch getrennt sind. Zu diesem Zweck weisen vorzugsweise die Gate-Treiber der Gate-Treiber-Schaltung eine galvanische Trennung auf. Beispielsweise können die Gate-Treiber-Schaltung bzw. die ein oder mehreren Gate-Treiber der Gate-Treiber-Schaltung ein oder mehrere Signalisolatoren zur galvanisch getrennten Übertragung von Steuersignalen von den ein oder mehreren Steuersignaleingängen zu den ein oder mehreren Treiberausgängen aufweisen. Die Signalisolatoren können beispielsweise ein oder mehrere Spannungswandler mit galvanischer Trennung aufweisen.

Umfasst die Gate-Treiber-Schaltung zudem ein oder mehrere Gate-Treiber-Spannungsversorgungsschaltungen mit einer jeweiligen Eingangsseite und einer jeweiligen Ausgangsseite, insbesondere zur Bereitstellung der Spannung oder des Stroms zur Ansteuerung der Leistungshalbleiter-Schaltelemente auf der Ausgangsseite, so umfassen die Gate-Treiber-Spannungsversorgungsschaltungen zudem vorzugsweise eine galvanische Trennung, insbesondere zwischen deren Eingangsseite und Ausgangsseite. Zu diesem Zweck können die ein oder mehreren Gate-Treiber-Spannungsversorgungsschaltungen insbesondere ein oder mehrere Spannungswandler, insbesondere DC/DC-Wandler, mit galvanischer Trennung aufweisen. Auf diese Weise kann aufseiten eines Treiberausgangs auch eine galvanisch getrennte Spannungsversorgung bereitgestellt werden. Dadurch kann sowohl hinsichtlich der Signalübertragung, insbesondere über einen jeweiligen Gate-Treiber, als auch hinsichtlich der Spannungsversorgung über eine zugehörige Gate-Treiber-Spannungsversorgungsschaltung eine galvanische Trennung des betreffenden Steuersignaleingangs von dem betreffenden Treiberausgang erreicht werden.

Durch die galvanische Trennung der ein oder mehreren Steuersignaleingänge von den ein oder mehreren Treiberausgängen kann eine Isolierung zwischen dem Steuerstromkreis und dem Primär-Potential erreicht werden. Die galvanische Trennung der ein oder mehreren Steuersignaleingänge von den ein oder mehreren Treiberausgängen kann mit einer doppelten oder verstärkten Isolierung oder alternativ mit lediglich einer Basis-Isolierung ausgeführt werden.

Vorzugsweise sind weiter auch die ein oder mehreren Treiberausgänge galvanisch voneinander getrennt, insbesondere mit mindestens einer Funktionsisolierung. Auf diese Weise wird eine für die Funktion wichtige Isolierung zwischen den unterschiedlichen Bezugspotentialen der verschiedenen Leistungshalbleiter-Schaltelemente erreicht.

Die Vorrichtung weist ein integriertes Leistungselektronik-Modul auf, das die Leistungshalbleiter-Schaltung und die Gate-Treiber-Schaltung umfasst. Die Leistungshalbleiter-Schaltung und die Gate-Treiber-Schaltung sind auf diese Weise in einem integrierten Modul untergebracht, das als Ganzes gehandhabt werden kann, ohne dass es bei der Montage, bei der Wartung oder bei Testläufen erforderlich ist, die Leistungshalbleiter-Schaltung und die Gate-Treiber-Schaltung separat zu handhaben. Darüber hinaus kann durch das integrierte Leistungselektronik-Modul ein Schutz der Leistungshalbleiter-Schaltung und der Gate-Treiber-Schaltung vor Verschmutzung erreicht werden, so dass für die Auslegung der Leistungshalbleiter-Schaltung und der Gate-Treiber-Schaltung lokal beispielweise ein geringerer Verschmutzungsgrad angenommen werden kann, was in Bezug auf die Isolationskoordination eine Bemessung mit deutlich kleineren Kriechstrecken erlaubt, während das integrierte Leistungselektronik-Modul in seiner Gesamtheit die Anforderungen für den Verschmutzungsgrad 3 erfüllt.

Darüber hinaus ermöglicht die Integration der Leistungshalbleiter-Schaltung und der Gate-Treiber-Schaltung in ein integriertes Leistungselektronik-Modul eine kompakte Ausgestaltung mit möglichst kurzen elektrischen Verbindungen und kleinen aufgespannten Flächen zwischen den ein oder mehreren Treiberausgängen und den Leistungshalbleiter-Schaltelementen der Leistungshalbleiter-Schaltung, wodurch schnellere Schaltvorgänge ermöglicht werden.

Das integrierte Leistungselektronik-Modul kann insbesondere eine Leiterplatte aufweisen, auf der sowohl die Leistungshalbleiter-Schaltung als auch die Gate-Treiber-Schaltung angeordnet sind. Auf diese Weise können die Leistungshalbleiter-Schaltung, insbesondere deren Leistungshalbleiter-Schaltelemente, und die Gate-Treiber-Schaltung besonders eng und kompakt angeordnet werden. Bei der Leiterplatte handelt es sich vorzugsweise um eine Metallkernleiterplatte, insbesondere um eine IMS-Leiterplatte (IMS - Insulated Metallic Substrate) oder um eine DBC-Leiterplatte (DBC - Direct bonded copper). Durch eine solche Metallkernleiterplatte kann eine bessere Wärmeableitung insbesondere von den Leistungshalbleiter-Schaltelementen der Leistungshalbleiter-Schaltung erreicht werden.

Das Integrieren der Leistungshalbleiter-Schaltung und der Gate-Treiber-Schaltung auf einer gemeinsamen Leiterplatte ermöglicht zudem eine einfache und kostengünstige Produktion, da die Produktion und Bestückung der Leiterplatte vollständig automatisiert erfolgen kann und das manuelle Verbinden separater Leistungshalbleiter- und Gate-Treiber-Module bzw. -Bauelemente entbehrlich wird. Gleichzeitig kann die potenzielle Fehlerquelle etwaiger (Steck-)Verbindungen zwischen Leistungshalbleiter-Schaltung und Gate-Treiber-Schaltung reduziert werden.

Die Leistungshalbleiter-Schaltung und die Gate-Treiber-Schaltung können insbesondere in dem Leistungselektronik-Modul mit einer Vergussmasse vergossen sein. Insbesondere können die Leistungshalbleiter-Schaltung und die Gate-Treiber-Schaltung zusammen mit der vorzugsweise gemeinsamen Leiterplatte und einem optional vorgesehenen Kunststoffrahmen mit einer Vergussmasse zu dem integrierten Leistungselektronik-Modul vergossen sein. Bei der Vergussmasse kann es sich insbesondere um ein Kunstharz, beispielsweise Epoxidharz, handeln.

Auf diese Weise kann das integrierte Leistungselektronik-Modul als monolithisches Modul ausgebildet werden, in dem die einzelnen Komponenten, insbesondere die Leistungshalbleiter-Schaltelemente der Leistungshalbleiter-Schaltung und die Gate-Treiber-Schaltung, besonders gut vor Verschmutzung geschützt sind, so dass für die Auslegung der Leistungshalbleiter-Schaltung und der Gate-Treiber-Schaltung lokal beispielweise ein Verschmutzungsgrad 1 angenommen werden kann, was in Bezug auf die Isolationskoordination eine Bemessung mit deutlich kleineren Kriechstrecken erlaubt, während das integrierte Leistungselektronik-Modul in seiner Gesamtheit die Anforderungen für den Verschmutzungsgrad 3 erfüllt.

Das Vergießen in Vergussmasse ist insbesondere für den Einsatz in Schweißgeräten, insbesondere Lichtbogenschweißgeräten, vorteilhaft, da diese gemäß der der Produktnorm IEC 60974-1 so ausgelegt werden müssen, dass sie in einer Umgebung mit Verschmutzungsgrad 3 sicher betrieben werden können. Dadurch ergeben sich für Schweißgeräte, insbesondere Lichtbogenschweißgeräte, höhere Anforderungen an Luft- und Kriechstrecken. Größere Isolations-Abstände vergrößern jedoch die mechanischen Abmessungen des Aufbaus und damit die Schleifenimpedanzen der Gate-Ansteuerstromkreise und der Kommutierungskreise im Leistungs-Stromkreis.

Produktnormen der meisten anderen elektrischen Betriebsmittel fordern demgegenüber lediglich eine Bemessung für Verschmutzungsgrad 2. Viele im Handel erhältliche, gängige und preiswerte Bauelemente sind daher auch nur für Verschmutzungsgrad 2 ausgelegt. Durch das Vergießen mit Vergussmasse können derartige Bauteile in dem integrierten Leistungselektronik-Modul auch in einem Schweißgerät, insbesondere Lichtbogenschweißgerät, verwendet werden.

Die zuvor genannte Aufgabe wird erfindungsgemäß weiterhin gelöst durch ein Schweißgerät, insbesondere Lichtbogenschweißgerät, das die zuvor beschriebene Vorrichtung zur Erzeugung eines Schweißstroms oder eine Ausführungsform davon umfasst. Bei dem Schweißgerät kann es sich beispielsweise um ein Schweißgerät zum Metallschutzgasschweißen mit abschmelzender Elektrode (z.B. MIG- oder MAG-Schweißen), um ein Schweißgerät zum Schweißen von Stabelektroden (sog. E-Hand-Schweißen) oder um ein Schweißgerät zum Schweißen mit nicht-abschmelzender Elektrode, insbesondere Wolfram-Inertgas-Schweißen (WIG-Schweißen), handeln.

Das Schweißgerät, insbesondere Lichtbogenschweißgerät, umfasst insbesondere eine Schweißstromquelle mit einem Schweißstromausgang zur Bereitstellung eines Schweißstromes. Die Schweißstromquelle umfasst vorzugsweise die Vorrichtung zur Erzeugung eines Schweißstroms, die in der Schweißstromquelle vorzugsweise derart verschaltet ist, um den Schweißstrom über den Schweißstromausgang der Schweißstromquelle bereitzustellen. Insbesondere kann die Vorrichtung zur Erzeugung eines Schweißstroms in einem Gehäuse der Schweißstromquelle untergebracht sein. Darüber hinaus kann die Schweißstromquelle zum Beispiel eine Nutzerschnittstelle aufweisen, über die ein Nutzer Informationen ablesen und/oder Steuerbefehle eingeben kann.

Der Schweißstromausgang umfasst vorzugsweise mindestens zwei Anschlüsse, insbesondere einen Anschluss zum Anschließen eines Schweißbrenners und einen Anschluss zum Anschließen einer Werkstückleitung.

Zum Schweißen kann an die Schweißstromquelle weitere Peripherie angeschlossen werden, beispielsweise eine Drahtvorschubvorrichtung (z.B. bei einem MIG/MAG-Schweißgerät) und/oder ein Schweißbrenner. Die Peripherie der Schweißstromquelle kann als Teil des Schweißgeräts angesehen werden. Das gegenständliche Schweißgerät kann jedoch zum Beispiel auch lediglich aus der Schweißstromquelle bestehen, die dann zum Beispiel mit separater Peripherie betrieben werden kann.

Im Folgenden werden verschiedene Ausführungsformen der Vorrichtung und des Schweißgeräts, insbesondere Lichtbogenschweißgeräts, beschrieben, wobei die einzelnen Ausführungsformen jeweils unabhängig voneinander für die Vorrichtung und das Schweißgerät gelten. Darüber hinaus können die einzelnen Ausführungsformen beliebig miteinander kombiniert werden.

Bei einer Ausführungsform ist mindestens einer der ein oder mehreren Leistungshalbleiter-Schaltelemente als Wide-Bandgap-Leistungshalbleiter-Schaltelement ausgebildet. Insbesondere können mehrere oder sämtliche der Leistungshalbleiter-Schaltelemente als Wide-Bandgap-Leistungshalbleiter-Schaltelemente ausgebildet sein.

Ein Wide-Bandgap-Leistungshalbleiter-Schaltelement basiert auf einem Wide-Bandgap-Halbleiter. Insbesondere basiert ein Transistor, beispielsweise Feldeffekttransistor oder Bipolartransistor, eines Wide-Bandgap-Leistungshalbleiter-Schaltelements auf einem Wide-Bandgap-Halbleiter.

Ein Wide-Bandgap-Halbleiter ist ein Halbleiter mit einer Bandlücke zwischen Valenz- und Leitungsband von mindestens 3 eV. Bei dem Wide-Bandgap-Halbleiter kann es sich insbesondere um SiC oder GaN handeln. Entsprechend kann das Leistungshalbleiter-Schaltelement insbesondere einen SiC-Transistor oder GaN-Transistor aufweisen. Bei dem SiC- oder GaN-Transistor kann es sich insbesondere um einen MOSFET oder um einen IGBT handeln.

Mit einem Wide-Bandgap-Leistungshalbleiter-Schaltelement können steilere Schaltflanken bzw. schnellere Schaltzeiten und dadurch höhere Taktfrequenzen erreicht werden. Auf diese Weise kann der Schweißstrom auf kürzeren Zeitskalen gesteuert und die Leistungsdichte, insbesondere aufgrund der möglichen Miniaturisierung des Leistungstransformators, erhöht werden.

Die Kombination einer Leistungshalbleiter-Schaltung auf Basis von Wide-Bandgap-Leistungshalbleiter-Schaltelementen mit einem integrierten Leistungselektronik-Modul, in dem neben der Leistungshalbleiter-Schaltung auch die Gate-Treiber-Schaltung untergebracht ist, ist besonders vorteilhaft, da durch die kompaktere Bauweise die jeweilige Verbindung zwischen jeweiligem Treiberausgang und zugehörigem Leistungshalbleiter-Schaltelement verkürzt und somit die Gate-Leitungsinduktivität deutlich reduziert werden kann. Auf diese Weise kann eine zuverlässige und präzise Ansteuerung auch bei schnellen Schaltvorgängen erreicht werden.

Bei einer Ausführungsform beträgt die Länge einer elektrischen Ansteuerleitung von einem der ein oder mehreren der Treiberausgänge der Gate-Treiber-Schaltung zu einem zugehörigen der ein oder mehreren Leistungshalbleiter-Schaltungselemente der Leistungshalbleiter-Schaltung max. 200 mm, vorzugsweise max. 120 mm. Vorzugsweise beträgt bei jedem der ein oder mehreren der Treiberausgänge die Länge einer elektronischen Ansteuerleitung von dem betreffenden Treiberausgang zu einem zugehörigen der ein oder mehreren Leistungshalbleiter-Schaltungselemente der Leistungshalbleiter-Schaltung max. 200 mm, vorzugsweise max. 120 mm.

Die Länge der Ansteuerleitung wird insbesondere vom IC-Anschluss eines ICs (IC: integrated circuit, auf Deutsch: integrierter Schaltkreis) der Gate-Treiber-Schaltung, insbesondere eines jeweiligen Gate-Treibers der Gate-Treiber-Schaltung, bis zum Gate-Anschluss des betreffenden Leistungshaltleiter-Schaltungselements gemessen. Der IC-Anschluss stellt damit den betreffenden Treiberausgang der Gate-Treiber-Schaltung dar.

Vorzugsweise ist bei einem, weiter bevorzugt bei jedem, der vorgesehenen Leistungshalbleiter-Schaltungselemente weiter eine Ansteuerrückleitung vorgesehen, die von einem Kelvin-Source-Anschluss des betreffenden Leistungshalbleiter-Schaltungselements zum Bezugspotential der Gate-Treiber-Schaltung verläuft. Vorzugsweise beträgt für einen, weiter bevorzugt für jeden, der ein oder mehreren Treiberausgänge die Gesamtlänge der jeweiligen Ansteuerleitung von dem betreffenden Treiberausgang zum Gate-Anschluss des zugehörigen Leistungshalbleiter-Schaltungselements und der jeweiligen Ansteuerrückleitung vom Kelvin-Source-Anschluss des zugehörigen Leistungshalbleiter-Schaltungselements zum Bezugspotential der Gate-Treiber-Schaltung in Summe max. 400 mm, vorzugsweise max. 240 mm.

Die Länge der Ansteuerrückleitung wird insbesondere vom Kelvin-Source-Anschluss des betreffenden Leistungshalbleiter-Schaltungselements bis zu einem IC-Anschluss eines ICs der Gate-Treiber-Schaltung, insbesondere eines jeweiligen Gate-Treibers der Gate-Treiber-Schaltung, gemessen, der auf einem Bezugspotential der Gate-Treiber-Schaltung liegt.

Der Begriff Kelvin-Source, wie in Kelvin-Source-Anschluss, wird vorliegend ungeachtet der Art der tatsächlich in den ein oder mehreren Leistungshalbleiter-Schaltelementen verwendeten Transistoren verwendet. So kann unter Kelvin-Source sowohl ein Source- oder Emitter-Anschluss eines Leistungstransistors mit einem separat für den Anschluss der Gate-Treiber-Schaltung herausgeführten Rückleiter der Gate-Ansteuerung als auch ein gemeinsam mit dem Leistungskreis genutzter Anschluss verstanden werden.

Zusätzlich oder alternativ spannen vorzugsweise für einen, weiter bevorzugt für jeden, der ein oder mehreren Treiberausgänge die zum zugehörigen Leistungshalbleiter-Schaltungselement führende Ansteuerleitung und die zu dem zugehörigen Leistungshalbleiter-Schaltungselement gehörige Ansteuerrückleitung zwischen sich eine Fläche mit einem Flächeninhalt von maximal 100 mm² auf. Zu diesem Zweck werden die Ansteuerleitung und die zugehörige Ansteuerrückleitung vorzugsweise zumindest abschnittsweise parallel nebeneinanderher, insbesondere dicht nebeneinanderher, geführt.

Bei der zu einem Treiberausgang gehörigen Ansteuerleitung und/oder Ansteuerrückleitung handelt es sich vorzugsweise jeweils um Leiterbahnen auf der Leiterplatte des integrierten Leistungselektronik-Moduls. Entsprechend handelt es sich bei der zwischen diesen Leitungen aufgespannten Fläche vorzugsweise um eine Fläche in der Ebene der Leiterplatte.

In die elektrische(n) Ansteuerleitung(en) und/oder die Ansteuerrückleitung(en) können elektronische Bauteile, wie zum Beispiel elektrische Widerstände o.ä., integriert sein. Diese werden bei der Länge der betreffenden Ansteuerleitung bzw. Ansteuerrückleitung bzw. bei der dazwischen aufgespannten Fläche mitgerechnet.

Durch diese Beschränkung der Längen der Ansteuerleitungen und ggf. Ansteuerrückleitungen bzw. des Flächeninhalts der zwischen einer Ansteuerleitung und zugehörigen Ansteuerrückleitung aufgespannten Flächen kann die parasitäre Schleifeninduktivität der durch diese Leitungen gebildeten Leiterschleife ausreichend reduziert werden, um die Leistungshalbleiter-Schaltelemente, insbesondere Wide-Bandgap-Leistungshalbleiter-Schaltelemente, mit steilen Schaltflanken zuverlässig betreiben zu können. Die Möglichkeit, die Leitungslängen bzw. Flächeninhalte auf diese Weise zu beschränken, insbesondere zu minimieren, ergibt sich vorliegend erst durch die Integration der Gate-Treiber-Schaltung und der Leistungshalbleiter-Schaltung in ein integriertes Leistungselektronik-Modul, vorzugsweise auf einer gemeinsamen Leiterplatte.

Bei einer Ausführungsform weist die Gate-Treiber-Schaltung ein oder mehrere Gate-Treiber auf, die jeweils dazu eingerichtet sind, die Ansteuerung von mindestens einem der ein oder mehreren Leistungshalbleiter-Schaltelemente über einen der Treiberausgänge abhängig von über mindestens einen der ein oder mehreren Steuersignaleingänge erhaltenen Steuersignalen zu bewirken. Insbesondere kann je Leistungshalbleiter-Schaltelement ein jeweiliger Gate-Treiber vorgesehen sein.

Vorzugsweise weisen die ein oder mehreren Gate-Treiber einen jeweiligen Signalisolator zur galvanisch getrennten Übertragung von über einen jeweiligen Steuersignaleingang erhaltenen Steuersignalen auf und sind dazu eingerichtet, die zur Ansteuerung eines jeweiligen der Leistungshalbleiter-Schaltelemente verwendete elektrische Leistung zumindest teilweise, vorzugsweise überwiegend, insbesondere praktisch vollständig, über eine vom Signalisolator separate Gate-Treiber-Spannungsversorgungsschaltung zu erhalten. Die vom Signalisolator separate Gate-Treiber-Spannungsversorgungsschaltung versorgt demnach insbesondere den Teil eines jeweiligen Gate-Treibers auf Seiten des betreffenden Treiberausgangs. Auf diese Weise erfolgt die Steuersignalübertragung separat von der Bereitstellung der zur Ansteuerung der Leistungshalbleiter-Schaltelemente erforderlichen Leistung, insbesondere des dafür erforderlichen Stroms.

Die Ansteuerung von Leistungshalbleiter-Schaltelementen erfordert typischerweise recht hohe Gateströme. Indem diese Ströme bzw. die Schaltleistung separat von der Signalübertragung durch die Gate-Treiber-Spannungsversorgungsschaltung bereitgestellt werden, kann die Signalübertragung auf geringe Ströme bzw. geringe Leistung beschränkt werden, wodurch höhere Schaltfrequenzen bzw. steilere Schaltflanken ermöglicht werden.

Bei einer Ausführungsform weist die Vorrichtung ein oder mehrere Gate-Treiber-Spannungsversorgungsschaltungen auf. Die ein oder mehreren Gate-Treiber-Spannungsversorgungsschaltungen dienen dazu, die Spannung bzw. den Strom zur Ansteuerung der Leistungshalbleiter-Schaltelemente durch die Gate-Treiber-Schaltung bereit zu stellen. Zu diesem Zweck weisen die ein oder mehreren Gate-Treiber-Spannungsversorgungsschaltungen vorzugsweise jeweils eine Eingangsseite zur Versorgung der jeweiligen Gate-Treiber-Spannungsversorgungsschaltung mit einer Eingangsspannung und/oder einem Eingangsstrom sowie eine Ausgangsseite zur Bereitstellung der Spannung und/oder des Stroms zur Ansteuerung der Leistungshalbleiter-Schaltelemente auf.

Die Gate-Treiber-Spannungsversorgungsschaltungen können auf diese Weise die zum Ansteuern der Leistungshalbleiter-Schaltelemente erforderliche Leistung separat von der Übertragung der Steuersignale bereitstellen und somit insbesondere die Gate-Treiber versorgen. Damit stellt eine solche Gate-Treiber-Spannungsversorgungsschaltung insbesondere eine Ausgestaltung einer separat vom Signalisolator vorgesehenen Gate-Treiber-Spannungsversorgungsschaltung dar, die die zur Ansteuerung eines betreffenden Leistungshalbleiter-Schaltelements verwendete elektrische Leistung zumindest teilweise, vorzugsweise überwiegend, insbesondere praktisch vollständig, bereitstellt.

Die ein oder mehreren Gate-Treiber-Spannungsversorgungsschaltungen können beispielsweise jeweils einen oder mehrere DC/DC-Wandler, vorzugsweise DC/DC-Wandler mit galvanischer Trennung, umfassen, die vorzugsweise zwischen die Eingangsseite und die Ausgangsseite der betreffenden Gate-Treiber-Spannungsversorgungsschaltung geschaltet sind. Beispielsweise kann je Leistungshalbleiter-Schaltelement eine Gate-Treiber-Spannungsversorgungsschaltung vorgesehen sein, die die Spannung bzw. den Strom zur Ansteuerung des betreffenden Leistungshalbleiter-Schaltelements durch die Gate-Treiber-Schaltung bereitstellt. Es ist jedoch auch denkbar, dass für mehrere Leistungshalbleiter-Schaltelemente eine gemeinsame Gate-Treiber-Spannungsversorgungsschaltung vorgesehen ist.

Die ein oder mehreren Gate-Treiber-Spannungsversorgungsschaltungen umfassen vorzugsweise jeweils eine galvanische Entkoppelung, insbesondere zwischen der Eingangsseite und der Ausgangsseite der betreffenden Gate-Treiber-Spannungsversorgungsschaltung. Auf diese Weise kann das am Gate anliegende Potential, insbesondere Primär-Potential, vom Potential einer die Gate-Treiber-Spannungsversorgungsschaltungen versorgenden Spannungsquelle, insbesondere Gate-Treiber-Spannungsquelle, und/oder vom Potential der Steuerelektronik galvanisch getrennt werden. Sind mehrere Gate-Treiber-Spannungsversorgungsschaltungen vorgesehen, sind vorzugsweise deren jeweilige Ausgangsseiten galvanisch voneinander getrennt.

Die jeweilige Eingangsseite der ein oder mehreren Gate-Treiber-Spannungsversorgungsschaltungen kann zum Beispiel an einem SELV-Stromkreis angeschlossen sein. In diesem Fall weist die Gate-Treiber-Spannungsversorgungsschaltung, insbesondere ein DC/DC-Wandler der Gate-Treiber-Spannungsversorgungsschaltung, vorzugsweise eine doppelte oder verstärkte Isolierung auf.

Weiterhin kann die jeweilige Eingangsseite der ein oder mehreren Gate-Treiber-Spannungsversorgungsschaltungen zum Beispiel auch an einem PELV-Stromkreis angeschlossen sein. In diesem Fall kann die Gate-Treiber-Spannungsversorgungsschaltung, insbesondere ein DC/DC-Wandler der Gate-Treiber-Spannungsversorgungsschaltung, beispielsweise lediglich eine Basis-Isolierung aufweisen. Auf diese Weise können die Kosten für die Gate-Treiber-Spannungsversorgungsschaltung reduziert werden.

Weiterhin ist es denkbar, dass die jeweilige Eingangsseite der ein oder mehreren Gate-Treiber-Spannungsversorgungsschaltungen an einen Stromkreis auf Primärpotential angeschlossen ist. In diesem Fall kann die Gate-Treiber-Spannungsversorgungsschaltung, insbesondere ein DC/DC-Wandler der Gate-Treiber-Spannungsversorgungsschaltung, beispielsweise lediglich eine Funktions-Isolierung aufweisen. Auf diese Weise können die Kosten für die Gate-Treiber-Spannungsversorgungsschaltung reduziert werden. Anstelle eines DC/DC-Wandlers kann die Gate-Treiber-Spannungsversorgungsschaltung bei dieser Ausgestaltung beispielsweise eine Bootstrap-Schaltung aufweisen.

Es ist weiterhin denkbar, dass die jeweilige Eingangsseite der ein oder mehreren Gate-Treiber-Spannungsversorgungsschaltungen durch eine gesonderte Spannungsversorgung versorgt wird, beispielsweise durch eine Batterie, beispielsweise eine wiederaufladbare Batterie (Akkumulator), oder durch eine Solarzelle.

Vorzugsweise umfasst das integrierte Leistungselektronik-Modul die ein oder mehreren Gate-Treiber-Spannungsversorgungsschaltungen. Auf diese Weise liegen insbesondere für die galvanische Trennung der ein oder mehreren Steuersignaleingänge von den ein oder mehreren Treiberausgängen vorgesehene Isolierungen und die zu dem jeweiligen Treiberausgang zugehörige Gate-Treiber-Spannungsversorgungsschaltung nah, insbesondere unmittelbar dicht, nebeneinander. Insbesondere können die ein oder mehreren Gate-Treiber-Spannungsversorgungsschaltungen als Teil der Gate-Treiber-Schaltung ausgebildet sein und vorzugsweise auf derselben Leiterplatte angeordnet sein wie die übrige Gate-Treiber-Schaltung und/oder die Leistungshalbleiter-Schaltung, besonders bevorzugt mit der Leiterplatte und der darauf angeordneten übrigen Gate-Treiber-Schaltung und/oder Leistungshalbleiter-Schaltung mittels einer Vergussmasse vergossen sein.

Bei einer Ausführungsform ist für mindestens einen, vorzugsweise jeden, der ein oder mehreren Treiberausgänge ein zugehöriger Miller-Clamp-Anschluss vorgesehen, der mit dem Gate-Anschluss des zugehörigen Leistungshalbleiter-Schaltungselements verbunden ist. Vorzugsweise ist der Miller-Clamp-Anschluss unmittelbar, insbesondere ohne zwischengeschaltete elektronische Bauelemente, mit dem Gate-Anschluss verbunden. Die Verbindung des Gate-Anschlusses mit dem Miller-Clamp-Anschluss stellt eine gesonderte niederohmige Verbindung zwischen dem Gate-Anschluss und der Gate-Treiber-Schaltung her. Die Gate-Treiber-Schaltung ist insbesondere dazu eingerichtet, den Miller-Clamp-Anschluss auf das Potential des zugehörigen Treiberausgangs zu schalten.

Auf diese Weise können beim schnellen Schalten eines Leistungshalbleiter-Schaltelements durch den Millereffekt am Gate-Anschluss eines anderen der Leistungshalbleiter-Schaltelemente auftretende Spannungsspitzen reduziert und damit ein unerwünschtes Schalten dieser anderen Leistungshalbleiter-Schaltelemente verhindert werden, da die Spannung am Gate-Anschluss des anderen Leistungshalbleiter-Schaltelements durch die niederohmige Verbindung zur Gate-Treiber-Schaltung über den Miller-Clamp-Anschluss auf dem gewünschten Potential gehalten werden kann. Parasitäre Einstreuungen von Schaltvorgängen anderer Leistungshalbleiter werden auf diese Weise reduziert, wodurch schnellere Schaltzeiten ermöglicht werden.

Diese Ausführungsform ist insbesondere vorteilhaft bei Verwendung eines Wide-Bandgap-Leistungshalbleiter-Schaltelements, da diese besonders schnelle Schaltzeiten und damit besonders steile Schaltflanken ermöglichen, so dass hier das Risiko unerwünschter Schaltvorgänge durch parasitäre Einstreuungen aufgrund des Millereffekts besonders hoch ist. Durch die Verwendung des Miller-Clamps kann dieses Risiko stark reduziert bzw. ausgeschlossen werden.

Bei einer Ausführungsform sind die ein oder mehreren Steuersignaleingänge der Gate-Treiber-Schaltung mit einem PELV-Signalstromkreis verbunden. Vorzugsweise ist der PELV-Signalstromkreis weiter über eine Signal-Entkoppelungsschaltung mit einem Steuerstromkreis gekoppelt, so dass Steuersignale von dem Steuerstromkreis auf den PELV-Signalstromkreis übertragen werden können, wobei die Signal-Entkoppelungsschaltung den PELV-Signalstromkreis und den Steuerstromkreis voneinander galvanisch trennt. Die Entkoppelungsschaltung umfasst vorzugsweise einen oder mehrere Signalisolatoren zur galvanisch getrennten Übertragung von Steuersignalen.

Die Signal-Entkoppelungsschaltung kann insbesondere zwischen einer Steuerelektronik zur Erzeugung der Steuersignale und den ein oder mehreren Steuersignaleingängen der Gate-Treiber-Schaltung geschaltet sein, so dass die Signal-Entkoppelungsschaltung die Steuerelektronik von den ein oder mehreren Steuersignaleingängen galvanisch trennt.

Die Verschaltung der Signal-Entkoppelungsschaltung mit dem Steuersignaleingang der Gate-Treiber-Schaltung umfasst weiter vorzugsweise eine Schutzerdung. Durch die galvanische Trennung in der Gate-Treiber-Schaltung sowie die galvanische Trennung in der Signal-Entkoppelungsschaltung wird auf diese Weise zwischen der Signal-Entkoppelungsschaltung, insbesondere deren Ausgang, und der Gate-Treiber-Schaltung, insbesondere deren ein oder mehreren Steuersignaleingängen, ein Schutzleiter-geerdeter Stromkreis (PELV-Stromkreis) für die Steuersignale (d.h. ein PELV-Signalstromkreis) bewirkt.

Zusätzlich oder alternativ können die ein oder mehreren Gate-Treiber-Spannungsversorgungsschaltungen mit einem PELV-Versorgungsstromkreis verbunden sein. Insbesondere kann der PELV-Versorgungsstromkreis über eine Versorgungs-Entkoppelungsschaltung mit einer Gate-Treiber-Spannungsquelle gekoppelt sein, wobei die Versorgungs-Entkoppelungsschaltung den PELV-Versorgungsstromkreis und die Gate-Treiber-Spannungsquelle voneinander galvanisch trennt. Die Versorgungs-Entkoppelungsschaltung weist vorzugsweise einen Spannungswandler, insbesondere DC/DC-Wandler, mit galvanischer Trennung auf. Der Spannungswandler mit galvanischer Trennung kann insbesondere einen Transformator oder eine gekoppelte Speicherdrossel aufweisen.

Der Spannungswandler mit galvanischer Trennung kann grundsätzlich aus einem beliebigen Stromkreis versorgt werden. Insbesondere kann der Spannungswandler mit galvanischer Trennung über den Steuerstromkreis bzw. aus einer Gate-Treiber-Spannungsquelle auf dem gleichen Potential wie der Steuerstromkreis versorgt werden. Dies ist jedoch nicht notwendig.

Die Verschaltung der Versorgungs-Entkoppelungsschaltung mit den ein oder mehreren Gate-Treiber-Spannungsversorgungsschaltungen umfasst weiter vorzugsweise eine Schutzerdung. Durch die vorzugsweise vorgesehene galvanische Trennung in den ein oder mehreren Gate-Treiber-Spannungsversorgungsschaltungen sowie die galvanische Trennung in der Versorgungs-Entkoppelungsschaltung wird auf diese Weise zwischen der Versorgungs-Entkoppelungsschaltung, insbesondere deren Ausgang, und den ein oder mehreren Gate-Treiber-Spannungsversorgungsschaltungen, ein Schutzleiter-geerdeter Stromkreis (PELV-Stromkreis) für die Spannungsversorgung (d.h. ein PELV-Versorgungsstromkreis) bewirkt.

Durch einen solchen PELV-Signalstromkreis und/oder PELV-Versorgungsstromkreis wird erreicht, dass auch bei dem Auftreten eines einzelnen Fehlers, beispielsweise bei einem Versagen der galvanischen Trennung in der Gate-Treiber-Schaltung bzw. einer Gate-Treiber-Spannungsversorgungsschaltung, das Auftreten von gefährlichen Spannungen am PELV-Signalstromkreis und der Steuerelektronik bzw. am PELV-Versorgungsstromkreis verhindert wird, so dass dieser Bereich der Gesamtschaltung weiterhin gefahrlos berührt werden kann. Auf diese Weise wird die Bedienungssicherheit erhöht, und insbesondere ein normkonformer und sicherer Betrieb der Schaltung möglich.

Durch das Vorsehen eines PELV-Signalstromkreises bzw. PELV-Versorgungsstromkreises in Kombination mit der galvanischen Trennung in der Gate-Treiber-Schaltung bzw. den ein oder mehreren Gate-Treiber-Stromversorgungsschaltungen wird insbesondere eine doppelte Isolierung gegenüber dem Steuerstromkreis bzw. einer Gate-Treiber-Spannungsquelle erreicht, so dass die Betriebssicherheit bei Auftreten eines Einfachfehlers gewährleistet ist. Darüber hinaus können durch diese Absicherung geringere Anforderungen an die Isolierung der Gate-Treiber-Schaltung bzw. Gate-Treiber-Spannungsversorgungsschaltungen, insbesondere deren Kriechstrecken, gestellt werden, wodurch sich der notwendige technische Aufwand zur Sicherstellung der Gerätesicherheit reduziert. Beispielsweise brauchen in der Gate-Treiber-Schaltung bzw. in den Gate-Treiber-Spannungsversorgungsschaltungen auf diese Weise die jeweilige galvanische Trennung lediglich für eine Basis-Isolierung anstelle einer doppelten oder verstärkten Isolierung bemessen werden.

Unter einem PELV-Stromkreis, wie zum Beispiel in PELV-Signalstromkreis bzw. PELV-Versorgungsstromkreis, wird vorliegend insbesondere ein PELV-Stromkreis gemäß EN 60208-1:2018 verstanden. Weiter wird unter einem PE-Schutzleiter vorliegend insbesondere ein Schutzleiter gemäß IEC 60204-1 verstanden.

Bei einer Ausführungsform umfasst das integrierte Leistungselektronik-Modul die Signal-Entkoppelungsschaltung und/oder die Versorgungs-Entkoppelungsschaltung. Auf diese Weise können insbesondere auch der PELV-Signalstromkreis und/oder der PELV-Versorgungsstromkreis in dem integrierten Leistungselektronik-Modul untergebracht werden. Dies ermöglicht es beispielsweise, für die Signal-Entkoppelungsschaltung bzw. für die Versorgungs-Entkoppelungsschaltung elektronische Bauteile einsetzen zu können, die als solche lediglich die normativen Anforderungen für Verschmutzungsgrad 1 oder 2 erfüllen, während das integrierte Leistungselektronik-Modul insgesamt die normativen Anforderungen für Verschmutzungsgrad 3 erfüllt.

Beispielsweise können ein Signalisolator der Signal-Entkoppelungsschaltung und ein DC/DC-Wandler der Versorgungs-Entkoppelungsschaltung vom integrierten Leistungselektronik-Modul umfasst sein, insbesondere auf derselben Leiterplatte wie die Gate-Treiber-Schaltung angeordnet sein. Es ist auch denkbar, dass ein Signalisolator der Signal-Entkoppelungsschaltung vom integrierten Leistungselektronik-Modul umfasst ist, insbesondere auf derselben Leiterplatte wie die Gate-Treiber-Schaltung angeordnet ist, während ein DC/DC-Wandler der Versorgungs-Entkoppelungsschaltung außerhalb des integrierten Leistungselektronik-Moduls angeordnet ist.

Bei einer alternativen Ausführungsform ist es denkbar, dass sowohl die Signal-Entkoppelungsschaltung, insbesondere ein Signalisolator der Signal-Entkoppelungsschaltung, als auch die Versorgungs-Entkoppelungsschaltung, insbesondere ein DC/DC-Wandler der Versorgungs-Entkoppelungsschaltung, außerhalb vom integrierten Leistungselektronik-Modul angeordnet sind.

Bei einer Ausführungsform ist eine Pulserzeugung vorgesehen, wobei die Pulserzeugung dazu eingerichtet ist, ein Schalten der Leistungshalbleiter-Schaltelemente mittels der Gate-Treiber-Schaltung mit einer Schaltfrequenz im Bereich von 20 bis 500 kHz, insbesondere 20 bis 200 kHz, zu bewirken. Vorzugsweise weist die Steuerelektronik die Pulserzeugung auf. Die Pulserzeugung kann beispielsweise einen Oszillator, wie einen Quarzoszillator, umfassen, der eine Betriebsfrequenz der Steuerelektronik vorgibt, sowie optional eine Schaltung und/oder Programmierung der Steuerelektronik, die auf Basis der Betriebsfrequenz die Schaltfrequenz bestimmt, mit der die Steuerelektronik Schaltsignale zum Schalten der Leistungshalbleiter-Schaltelemente ausgibt.

Durch die Integration von Gate-Treiber-Schaltung und Leistungshalbleiter-Schaltung in ein integriertes Leistungselektronik-Modul sowie den vorzugsweisen Einsatz von Wide-Bandgap-Leistungshalbleiter-Schaltelementen, können die Schaltverluste der Leistungshalbleiter-Schaltung wesentlich reduziert werden. Dies ermöglicht den Betrieb der Leistungshalbleiter-Schaltung mit einer höheren Taktfrequenz im Bereich von 20 bis 500 kHz, insbesondere 20 bis 200 kHz, ohne dass sich die abgegebene Verlustleistung unverhältnismäßig erhöht.

Die höhere Taktfrequenz hat zudem den Vorteil, dass der Wechselanteil des Schweißstroms (sogenannter Rippelstrom) sich dadurch bei gleicher Ausgangsinduktivität reduziert und der Schweißlichtbogen damit ruhiger und stabiler wird, so dass ein besserer Schweißprozess ermöglicht wird.

Weitere Merkmale und Vorteile der Vorrichtung und des Schweißgeräts ergeben sich aus der nachfolgenden Beschreibung von Ausführungsbeispielen, wobei auf die beigefügte Zeichnung Bezug genommen wird.

In der Zeichnung zeigen
- Fig. 1: ein Ausführungsbeispiel des Schweißgeräts in schematischer Darstellung,
- Fig. 2: das Leistungsteil der Schweißstromquelle des Schweißgeräts aus Fig. 1 mit einem Ausführungsbeispiel der Vorrichtung,
- Fig. 3a-b: das integrierte Leistungselektronik-Modul des Leistungsteils aus Fig. 2,
- Fig. 4: einen schematischen Schaltplan des integrierten Leistungselektronik-Moduls aus Fig. 3 mit angeschlossenen Komponenten,
- Fig. 5: ein zum Leistungsteil aus Fig. 2 alternatives Leistungsteil der Schweißstromquelle des Schweißgeräts aus Fig. 1 mit einem weiteren Ausführungsbeispiel der Vorrichtung und
- Fig. 6: einen schematischen Schaltplan des integrierten Leistungselektronik-Moduls aus Fig. 5 mit angeschlossenen Komponenten.

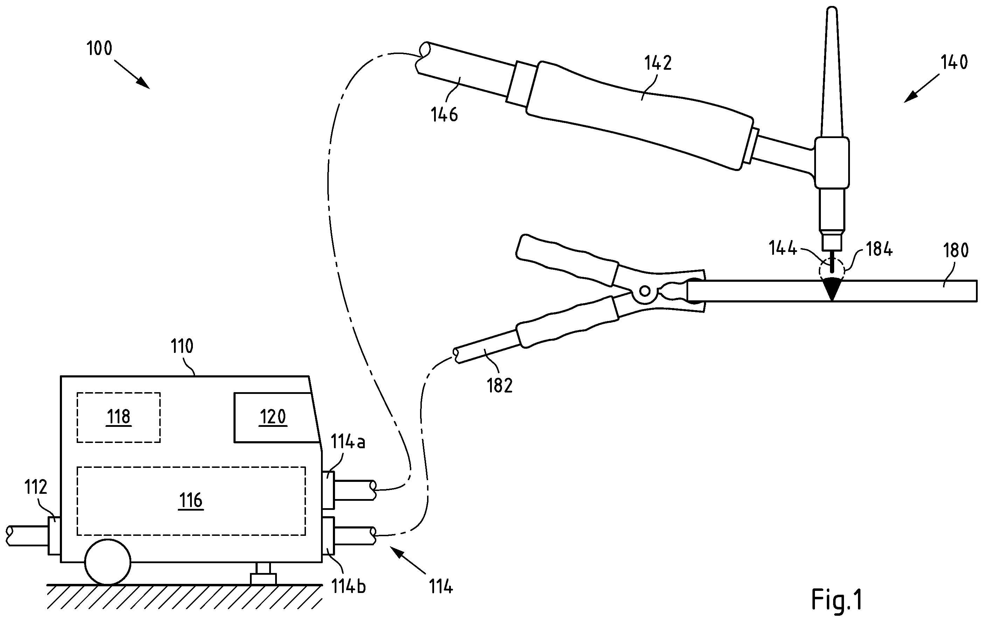

Fig. 1 zeigt ein Ausführungsbeispiel eines Schweißgeräts, nämlich eines Lichtbogenschweißgeräts. Das Lichtbogenschweißgerät 100 ist im vorliegenden Beispiel zum Wolfram-Inertgas-Schweißen (WIG-Schweißen) ausgebildet. Alternativ könnte das Lichtbogenschweißgerät 100 beispielsweise auch zum Metallschutzgas-(MSG)-schweißen, beispielsweise zum Metall-Inertgas-(MIG)- und/oder Metall-Aktivgas-(MAG)-Schweißen, oder zum E-Hand-Schweißen ausgebildet sein.

Das Lichtbogenschweißgerät 100 umfasst eine Schweißstromquelle 110 mit einem Netzanschluss 112 zum Anschließen der Schweißstromquelle 110 an das Stromnetz oder eine andere Spannungsversorgung und mit einem Schweißstromausgang 114, der einen ersten Anschluss 114a für einen Schweißbrenner und einen zweiten Anschluss 114b für eine Werkstückkontaktierung umfasst. Die Schweißstromquelle 110 umfasst weiter ein Leistungsteil 116 zur Bereitstellung eines Schweißstroms, eine Steuereinrichtung 118 zur Steuerung der Schweißstromquelle 110 sowie eine Nutzerschnittstelle 120, über die der Nutzer Betriebsinformationen ablesen und/oder Steuerbefehle eingeben kann. Das Leistungsteil 116 ist dazu eingerichtet, einen Schweißstrom zum Schweißen über die elektrischen Anschlüsse 114a-b der Schweißstromquelle 110 bereitzustellen.

Das Lichtbogenschweißgerät 100 umfasst weiter einen WIG-Schweißbrenner 140, der ein Brennerteil 142 mit einer nicht-abschmelzenden Elektrode 144 und ein Anschlusskabel 146 aufweist. Durch eine Kontaktierung im Brennerteil 142 kann im Betrieb ein über den Anschluss 114a und das Anschlusskabel 146 fließender Schweißstrom auf die Elektrode 144 geleitet werden.

Für den Betrieb wird der WIG-Schweißbrenner 140 mit seinem Anschlusskabel 146 an den ersten Anschluss 114a der Schweißstromquelle 110 angeschlossen. Das zu schweißende Werkstück 180 wird für den Schweißvorgang über eine Werkstückleitung 182 mit dem zweiten Anschluss 114b der Schweißstromquelle 110 verbunden, so dass der elektrische Schweißstromkreis beim Schweißvorgang über die Lichtbogenstrecke 184 zwischen Elektrode 144 und Werkstück 180 geschlossen wird.

Der WIG-Schweißbrenner 140 und die Werkstückleitung 182 stellen Peripherie der Schweißstromquelle 110 dar. Im vorliegenden Ausführungsbeispiel wird diese Peripherie als Teil des Lichtbogenschweißgeräts 100 beschrieben. Alternativ kann auch lediglich die Schweißstromquelle 110 als Lichtbogenschweißgerät angesehen werden, die dann mit separater Peripherie betrieben werden kann.

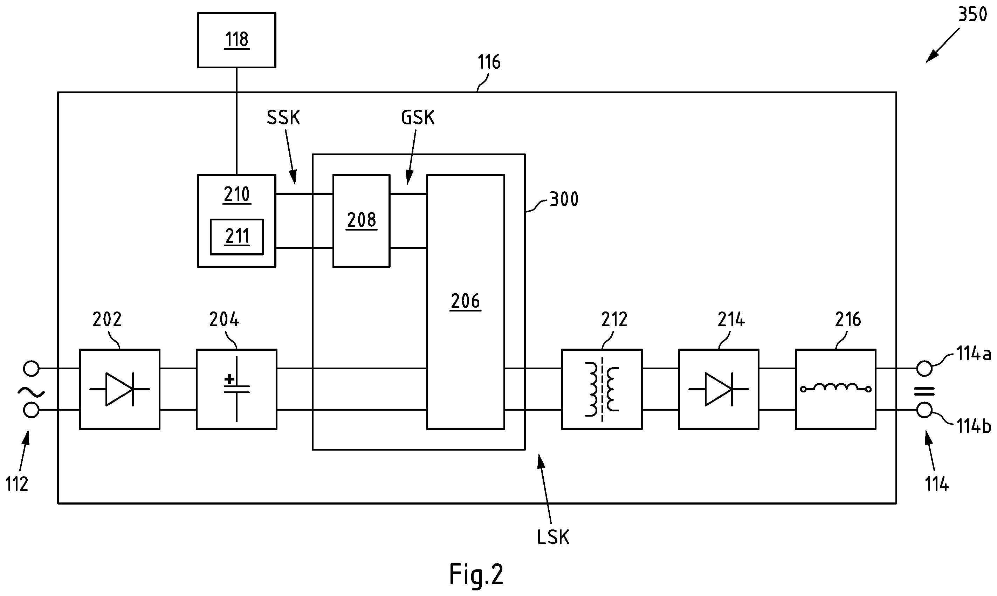

Fig. 2 zeigt das Leistungsteil 116 der Schweißstromquelle 110 in schematischer Blockdarstellung. Das Leistungsteil 116 umfasst einen Eingangs-Gleichrichter 202, einen Gleichspannungs-Zwischenkreis 204, eine Leistungshalbleiter-Schaltung 206, eine Gate-Treiber-Schaltung 208, eine Steuerelektronik 210, einen Transformator 212, einen Ausgangs-Gleichrichter 214 und eine Ausgangsdrossel 216.

Der Eingangs-Gleichrichter 202 wandelt eine am Netzanschluss 112 anliegende Wechselspannung in Gleichspannung um und speist den Gleichspannungs-Zwischenkreis 204. In Fig. 2 ist exemplarisch ein einphasiger Netzanschluss 112 (mit Anschlüssen für eine Phase und einen Nullleiter) gezeigt. Stattdessen kann zum Beispiel auch ein Netzanschluss 122 für Drehstrom (mit drei Phasen-Anschlüssen und einem Nulleiter-Anschluss) oder für Gleichstrom vorgesehen sein. Bei einem Netzanschluss 122 für Gleichstrom entfällt der Eingangs-Gleichrichter 202.

Der Gleichspannungs-Zwischenkreis 204 dient als Ladungszwischenspeicher, um die mittels der Leistungshalbleiter-Schaltung 206 geschalteten hohen primärseitigen Transformatorströme bereitstellen zu können. Anstelle des Gleichspannungs-Zwischenkreises 204 können zum Beispiel auch geteilte Gleichspannungs-Zwischenkreise vorgesehen sein, die jeweils mit der Leistungshalbleiter-Schaltung 206 verbunden sind. Die Anzahl der in Fig. 2 zwischen dem Gleichspannungs-Zwischenkreises 204 und der Leistungshalbleiter-Schaltung 206 eingezeichneten Verbindungen ist lediglich exemplarisch.

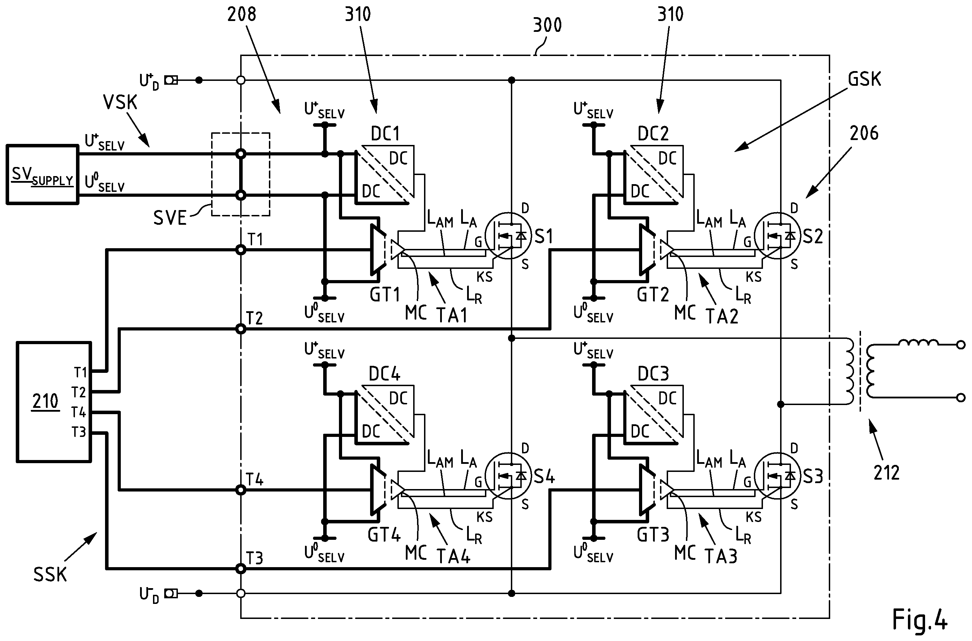

Die Leistungshalbleiter-Schaltung 206 wird durch die Gate-Treiber-Schaltung 208 angesteuert, die wiederum durch die Steuerelektronik 210 gesteuert wird. Die Steuerelektronik 210 ist vorzugsweise mit der Steuereinrichtung 118 verbunden und kann dadurch durch diese gesteuert, insbesondere parametriert werden. In Fig. 2 sind zwischen der Steuerelektronik 210 und der Gate-Treiber-Schaltung 208 der Übersicht halber lediglich zwei Verbindungen, nämlich eine Steuersignalverbindung (oben) und eine Bezugspotential-Verbindung (unten) gezeigt. Tatsächlich verlaufen zwischen der Steuerelektronik 210 und der Gate-Treiber-Schaltung 208 typischerweise etliche Verbindungen, insbesondere mindestens eine Verbindung je Steuersignaleingang der Gate-Treiber-Schaltung 208 (s. z.B. Fig. 4).

Der durch die Leistungshalbleiter-Schaltung 206 bereitgestellte primärseitige Transformatorstrom wird weiter durch den Transformator 212 transformiert und durch den Ausgangs-Gleichrichter 214 gleichgerichtet, so dass der Schweißstrom als gesteuerter Gleichstrom über den Schweißstromausgang 114 bereitgestellt wird. In Fig. 2 sind zwischen Leistungshalbleiter-Schaltung 206 und Transformator 212 der Übersicht halber lediglich zwei Verbindungen dargestellt. Stattdessen können auch mehr als zwei Verbindungen vorgesehen sein, beispielsweise drei Leitungen bei Verwendung einer Push-Pull-Topologie.

Im vorliegenden Beispiel ist die Schweißstromquelle 110 als Gleichstrom-Schweißstromquelle ausgebildet. Alternativ kann die Schweißstromquelle 110 auch als Wechselstrom-Schweißstromquelle ausgebildet sein. In diesem Fall kann das Leistungsteil 116 zwischen dem Ausgangs-Gleichrichter 214 und dem Schweißstromausgang 114 noch einen Wechselrichter aufweisen.

Der Stromkreis vom Netzanschluss 112 bis zum Schweißstromausgang 114 stellt einen Leistungsstromkreis LSK der Schweißstromquelle 110 dar.

Die Leistungshalbleiter-Schaltung 206 und die Gate-Treiber-Schaltung 208 sind bei dem Leistungsteil 116 Teil eines integrierten Leistungselektronik-Moduls 300.

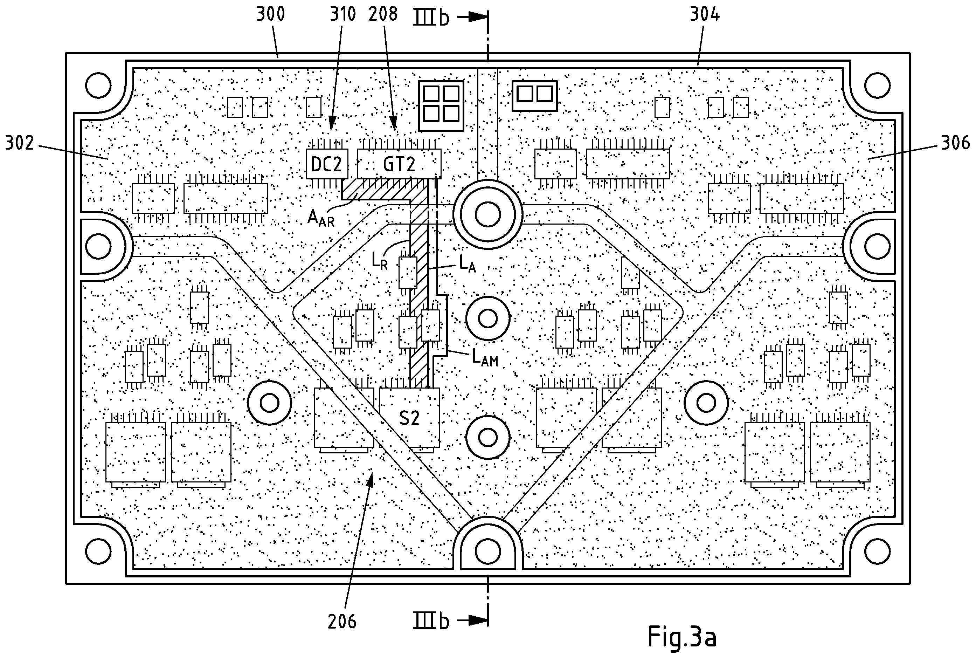

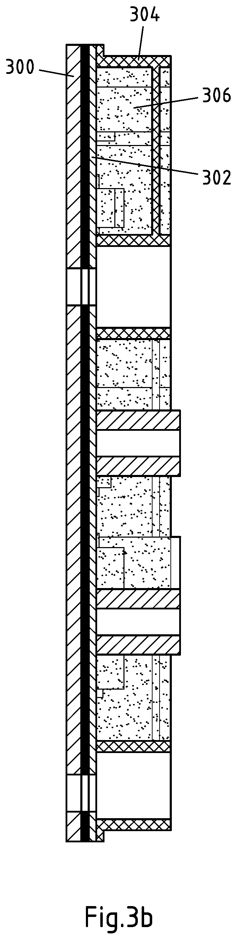

Die Fig. 3a-b zeigt eine hochschematische Darstellung des Leistungselektronik-Moduls 300 in Aufsicht (Fig. 3a) sowie in Schnittansicht (Fig. 3b) entsprechend der in Fig. 3a mit "IIIb" bezeichneten Schnittebene. Die Art, Anzahl und Anordnung der elektronischen Bauteile ist lediglich exemplarisch.

Das Leistungselektronik-Modul 300 weist eine Leiterplatte 302 auf, auf der sowohl die Leistungshalbleiter-Schaltung 206 als auch die Gate-Treiber-Schaltung 208 angeordnet sind. Bei der Leiterplatte 302 handelt es sich um eine Metallsubstrat-Leiterplatte, die somit eine bessere Abführung der Wärme von den Leistungshalbleitern der Leistungshalbleiter-Schaltung 206 erlaubt. Mit der Leiterplatte 302 ist ein Kunststoffrahmen 304 verschraubt und der Kunststoffrahmen 304 und die Leiterplatte 302 mit der darauf angeordneten Leistungshalbleiter-Schaltung 206 und Gate-Treiber-Schaltung 208 ist mit einer Vergussmasse 306, insbesondere Kunstharz, vergossen und bilden das integrierte Leistungselektronik-Modul 300.

Das Leistungsteil 116 mit dem Leistungselektronik-Modul 300 bildet eine Vorrichtung 350 zur Erzeugung eines Schweißstroms für das Lichtbogenschweißgerät 100 und stellt ein Ausführungsbeispiel der Vorrichtung zur Erzeugung eines Schweißstroms für ein Schweißgerät, insbesondere Lichtbogenschweißgerät, dar.

Fig. 4 zeigt einen möglichen Schaltplan des integrierten Leistungselektronik-Moduls 300 der Vorrichtung 350.

Die Leistungshalbleiter-Schaltung 206 weist vier Leistungshalbleiter-Schaltelemente S1 - S4 auf, die vorliegend jeweils einen SiC-Feldeffekttransistor mit den jeweiligen Anschlüssen Drain (D), Gate (G) und Source (S) umfassen und somit als Wide-Bandgap-Leistungshalbleiter-Schaltelemente ausgebildet sind. Daneben weisen die SiC-Feldeffekttransistoren jeweils noch einen Kelvin-Source-Anschluss (KS) auf. Jeweils antiparallel zu den SiC-Feldeffekttransistoren bildet deren p-n Übergang eine intrinsische Body-Diode.

Die Leistungshalbleiter-Schaltelemente S1 - S4 sind bei der Leistungshalbleiter-Schaltung 206 in Vollbrückenschaltung zwischen den Gleichspannungs-Zwischenkreis 204 (mit den Polen U⁺_{D} und U⁻_{D}) und den Transformator 212 geschaltet. Zu diesem Zweck sind jeweils zwei der Leistungshalbleiter-Schaltelemente, nämlich einerseits die Leistungshalbleiter-Schaltelemente S1 und S4 und andererseits die Leistungshalbleiter-Schaltelemente S2 und S3, in Reihe zwischen die beiden Pole U⁺_{D} und U⁻_{D} des Gleichspannungs-Zwischenkreises 204 geschaltet, wobei ein jeweiliger Zwischenabgriff der in Reihe geschalteten Leistungshalbleiter-Schaltelemente mit einem jeweiligen Anschluss des Transformators 212 verbunden ist.

Die Gate-Treiber-Schaltung 208 umfasst für jedes der Leistungshalbleiter-Schaltelemente S1 - S4 einen jeweiligen Steuersignaleingang T1 - T4, der mit einem entsprechenden Steuerausgang der Steuerelektronik 210 verbunden ist.

Weiter umfasst die Gate-Treiber-Schaltung 208 einen Spannungsversorgungseingang (SVE), die mit einer Gate-Treiber-Spannungsquelle (SV_{SUPPLY}) für Sicherheits-Kleinspannung (SELV) verbunden ist. Bei der Gate-Treiber-Spannungsquelle SV_{SUPPLY} kann es sich - wie im vorliegenden Ausführungsbeispiel der Fall - insbesondere um dieselbe Spannungsquelle handeln, die die Steuerelektronik 210 versorgt. Die Gate-Treiber-Spannungsquelle SV_{SUPPLY} kann beispielsweise ein Netzteil umfassen, das die über den Netzanschluss 112 bereitgestellte Netzspannung in eine Sicherheits-Kleinspannung wandelt. Die von der Gate-Treiber-Spannungsquelle SV_{SUPPLY} bereitgestellten Spannungspotentiale werden in Fig. 4 als U⁺_{SELV} bzw. U⁰_{SELV} bezeichnet. In einem alternativen Ausführungsbeispiel kann zur Versorgung der für die Steuerelektronik 210 aber auch eine gesonderte Spannungsquelle vorgesehen sein, beispielsweise ein gesondertes Netzteil.

Die Gate-Treiber-Schaltung 208 umfasst für jedes der Leistungshalbleiter-Schaltelemente S1 - S4 einen Gate-Treiber mit galvanischer Trennung (GT1 - GT4), der im vorliegenden Ausführungsbeispiel einen jeweiligen Signalisolator mit galvanischer Trennung aufweist. Ein solcher Signalisolator ermöglicht die Übertragung von Schaltsignalen von einem Signaleingang des Signalisolators zu einem Signalausgang des Signalisolators mit galvanischer Trennung zwischen Signaleingang und Signalausgang.

Die in Fig. 4 jeweils linke Seite der Gate-Treiber GT1 - GT4 stellt die jeweilige Eingangsseite und die in Fig. 4 jeweils rechte Seite die Ausgangsseite des betreffenden Gate-Treibers GT1 - GT4 dar. Für jedes der Leistungshalbleiter-Schaltelemente S1 - S4 ist der zugehörige Steuersignaleingang T1 - T4 mit dem Signaleingang an der Eingangsseite des zugehörigen Gate-Treibers GT1 - GT4 und der Signalausgang an der Ausgangsseite des zugehörigen Gate-Treibers GT1 - GT4 über eine Ansteuerleitung L_{A} mit dem jeweiligen Gate-Anschluss G des jeweiligen Leistungshalbleiter-Schaltelementes S1 - S4 verbunden. In die Ansteuerleitung L_{A} können zur genaueren und/oder schnelleren Ansteuerung der Wide-Bandgap-Schaltelemente, im vorliegenden Beispiel der SiC-Feldeffekttransistoren, elektronische Bauelemente, wie zum Beispiel Widerstände oder Kondensatoren, integriert sein. Diese sind in Fig. 4 der Übersicht halber nicht dargestellt.

Die Gate-Treiber GT1 - GT4 weisen neben dem jeweiligen Signalausgang vorzugsweise jeweils noch einen Miller-Clamp-Anschluss MC auf, der über eine Miller-Ansteuerleitung L_{AM} parallel zur Ansteuerleitung L_{A} mit dem Gate-Anschluss G verbunden ist. Anders als die Ansteuerleitung L_{A} sind in die Miller-Ansteuerleitung L_{AM} keine elektronischen Bauelemente integriert, so dass über die Miller-Ansteuerleitung L_{AM} und den Miller-Clamp-Anschluss MC eine möglichst niederohmige Verbindung zwischen dem jeweiligen Gate-Anschluss G und dem jeweiligen der Gate-Treiber GT1 - GT4 zur Verfügung steht, über die der Gate-Anschluss G außerhalb von Schaltvorgängen an dem betreffenden Leistungshalbleiter-Schaltelement S1 - S4 auf einem festen Potential, beispielsweise Basispotential, festgehalten werden kann.

Weiter weisen die Gate-Treiber GT1 - GT4 auf der Ausgangsseite jeweils einen Basispotential-Anschluss auf, mit dem der Kelvin-Source-Anschluss KS des jeweiligen Leistungshalbleiter-Schaltelements S1 - S4 über eine jeweilige Ansteuerrückleitung L_{R} verbunden ist.

Der Signalausgang und der Basispotential-Anschluss eines jeweiligen Gate-Treibers GT1 - GT4 stellen einen jeweiligen Treiberausgang TA1 - TA4 der Gate-Treiber-Schaltung 208 dar.

Die Gate-Treiber-Schaltung 208 umfasst weiter für jedes der Leistungshalbleiter-Schaltelemente S1 - S4 eine Gate-Treiber-Spannungsversorgung 310 mit einem jeweiligen DC/DC-Wandler mit galvanischer Trennung (DC1 - DC4). Die in Fig. 4 jeweils linke Seite der DC/DC-Wandler stellt die Eingangsseite und die in Fig. 4 jeweils rechte Seite der DC/DC-Wandler stellt die Ausgangsseite der jeweiligen Gate-Treiber-Spannungsversorgung 310 dar.

Die jeweiligen DC/DC-Wandler sind an ihrer Eingangsseite jeweils mit dem Spannungsversorgungseingang SVE verbunden und stellen an ihrer Ausgangsseite eine jeweilige von dem Spannungsversorgungseingang SVE galvanisch getrennte Versorgungsspannung zur Versorgung des ausgangsseitigen Teils des jeweiligen Gate-Treibers GT1 - GT4 und insbesondere die für die Ansteuerung des jeweiligen Leistungshalbleiter-Schaltelements S1 - S4 erforderliche Spannung bzw. den dafür erforderlichen Strom zur Verfügung. Die Versorgung des jeweiligen Gate-Treibers GT1 - GT4 durch den jeweiligen DC/DC-Wandler ist in Fig. 4 der Übersicht halber durch lediglich eine Verbindung symbolisiert. Tatsächlich können jedoch auch mehrere Verbindungen vorgesehen sein.

Die Gate-Treiber-Spannungsversorgungen 310 sind vorliegend als Teil der Gate-Treiber-Schaltung 208 ausgebildet und auf derselben Leiterplatte 302 als Teil des Leistungselektronik-Moduls 300 ausgebildet.

Durch die galvanische Trennung in den Gate-Treibern GT1 - GT2 sind die einzelnen Treiberausgänge TA1 - TA4 jeweils von den Steuersignaleingängen T1 - T4 getrennt. Es ergeben sich auf diese Weise jeweils zwei galvanisch voneinander getrennte Stromkreise, nämlich zum einen ein Steuerstromkreis SSK (SELV-Spannungsbereich) mit der Eingangsseite der Gate-Treiber GT1 - GT4 sowie ein Gate-Ansteuerstromkreis GSK (Primär-Spannungsbereich) mit der Ausgangsseite der Gate-Treiber GT1 - GT4. Der Steuerstromkreis SSK und der Gate-Ansteuerstromkreis GSK sind in Fig. 4 zur Verdeutlichung mit unterschiedlich dicken Linien gezeichnet (dicke Linien: Steuerstromkreis, dünne Linien: Gate-Ansteuerstromkreis).

Darüber hinaus sind die Treiberausgänge TA1 - TA4 durch die galvanische Trennung in den DC/DC-Wandlern DC1 - DC4 auch vom Spannungsversorgungseingang SPE getrennt, so dass sich auf diese Weise weiter ein vom jeweiligen Gate-Ansteuerstromkreis GSK getrennter Versorgungsstromkreis VSK (SELV-Spannungsbereich) mit der jeweiligen Eingangsseite der Gate-Treiber-Spannungsversorgungen 310, d.h. der Eingangsseite der DC/DC-Wandler DC1 - DC4, ergibt. Die jeweilige Ausgangsseite der Gate-Treiber-Spannungsversorgungen 310, d.h. der DC/DC-Wandler DC/DC-Wandler DC1 - DC4, gehört zum jeweiligen Gate-Ansteuerstromkreis GSK.

Demnach wird auf diese Weise insbesondere eine galvanische Trennung der Steuersignaleingänge von den Treiberausgängen und von der Leistungshalbleiter-Schaltung bewirkt, so dass an den Steuersignaleingängen T1 - T4 bzw. an der Steuerelektronik 210 keine Primär-Spannungen anliegen.

Darüber hinaus ermöglicht die Integration von Gate-Treiber-Schaltung 208 und Leistungshalbleiter-Schaltung 206 auf einer Leiterplatte 302 möglichst kurze Verbindungen und damit eine möglichst geringe Schleifeninduktivität des Gate-Ansteuerstromkreises GSK, insbesondere der durch die Ansteuerleitung L_{A} und die Ansteuerrückleitung L_{R} gebildeten Schleife.

Die Schleifeninduktivität kann insbesondere dadurch reduziert werden, dass die jeweilige Ansteuerleitung L_{A} und die zugehörige Ansteuerrückleitung L_{R} möglichst kurz, vorzugsweise mit einer Länge von in Summe maximal 400 mm, insbesondere maximal 240 mm ausgeführt werden. Weiter kann die Schleifeninduktivität dadurch reduziert werden, dass die zwischen der jeweiligen Ansteuerleitung L_{A} und der zugehörigen Ansteuerrückleitung L_{R} aufgespannte Fläche A_{AR} auf der Leiterplatte 302 einen Flächeninhalt von maximal 100 mm² aufweist (s. Fig. 3). Dies kann insbesondere dadurch erreicht werden, dass die jeweilige Ansteuerleitung L_{A} und die zugehörige Ansteuerrückleitung L_{R} zumindest abschnittsweise parallel nebeneinanderher geführt werden, wie es in Fig. 3a exemplarisch für den Gate-Treiber GT2 schematisch illustriert ist.

Im Betrieb sendet die Steuerelektronik 210 Steuersignale an die Steuersignaleingänge T1 - T4 zur Ansteuerung der einzelnen Leistungshalbleiter-Schaltelemente S1 - S4.

Die Gate-Treiber-Schaltung 208 steuert sodann die Leistungshalbleiter-Schaltelemente S1 - S4 über die jeweiligen Gate-Anschlüsse G entsprechend an. Die Schaltfrequenz, mit der die Steuerelektronik 210 die Gate-Treiber-Schaltung 208 und die Gate-Treiber-Schaltung 208 entsprechend die Leistungshalbleiter-Schaltelemente S1 - S4 ansteuert, wird von einer Pulserzeugung 211 in der Steuerelektronik 210 vorgegeben. Die Pulserzeugung 211 kann beispielsweise einen Quarzoszillator umfassen, der die Betriebsgrundfrequenz der Steuerelektronik 210 vorgibt, sowie eine Schaltung und/oder Programmierung innerhalb der Steuerelektronik 210, durch die die Schaltfrequenz basierend auf der Betriebsgrundfrequenz festgelegt wird. Durch die geringe Schleifeninduktivität zwischen Gate-Treiber-Schaltung 208 und Leistungshalbleiter-Schaltung 206 kann die Schaltfrequenz bei der Schaltung in Fig. 4 recht hoch, zum Beispiel im Bereich 20 - 500 kHz, insbesondere 200 - 500 kHz, eingestellt werden, ohne dass es im Betrieb zu Störungen durch parasitäre Kopplungen zwischen den Leistungshalbleiter-Schaltelementen während der Schaltvorgänge kommt.

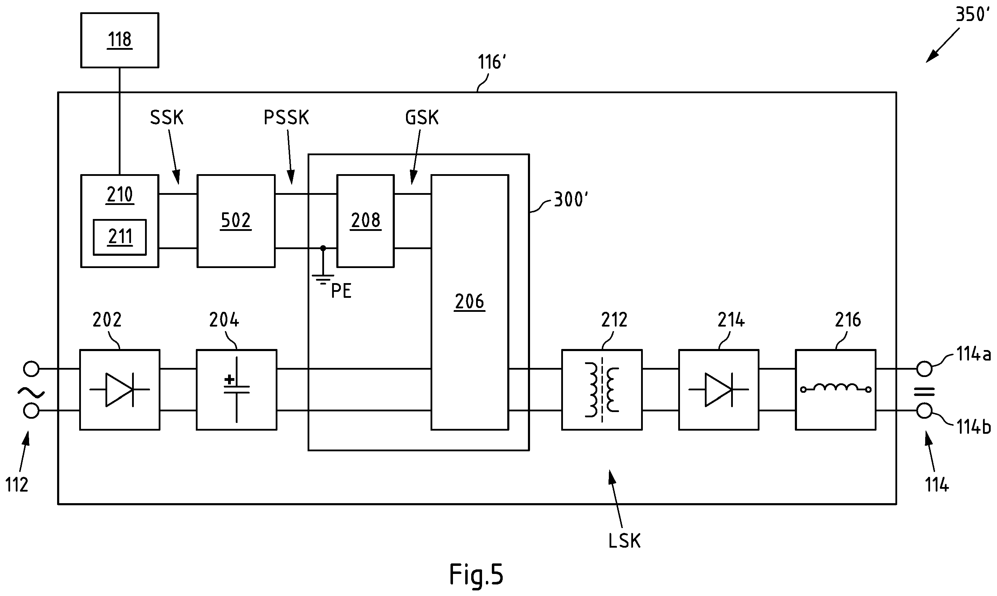

Fig. 5 zeigt ein alternatives Leistungsteil 116' für die Schweißstromquelle 110 in schematischer Blockdarstellung. Das Leistungsteil 116' weist einen ähnlichen Aufbau und eine ähnliche Funktionsweise auf wie das Leistungsteil 116' aus Fig. 3. Einander entsprechende Komponenten sind mit denselben Bezugszeichen versehen wie in Fig. 3 und es wird insoweit auf die Beschreibung von Fig. 3 verwiesen.

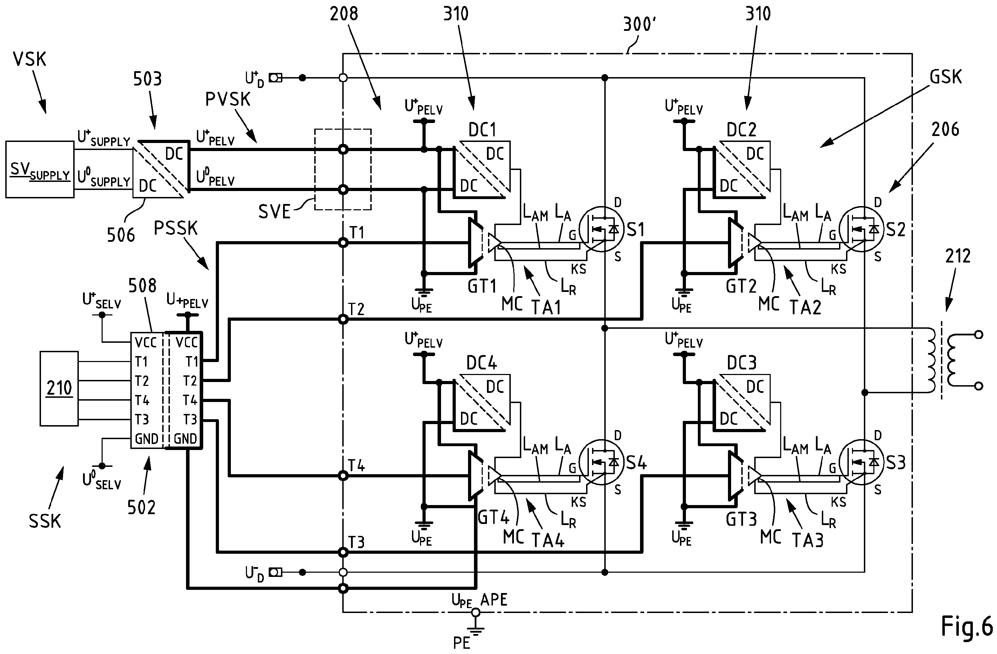

Das Leistungsteil 116' unterscheidet sich dadurch vom Leistungsteil 116, dass zwischen der Steuerelektronik 210 und der Gate-Treiber-Schaltung 208 eine Signal-Entkoppelungsschaltung 502 mit galvanischer Trennung vorgesehen ist und der auf diese Weise zwischen Steuerstromkreis SSK und Gate-Ansteuerstromkreis GSK geschaltete und von diesen jeweils galvanisch entkoppelte Stromkreis als PELV-Signalstromkreis PSSK ausgebildet ist. Weiterhin ist zwischen der Gate-Treiber-Versorgungsspannungsquelle SV_{SUPPLY} und den Gate-Treiber-Spannungsversorgungsschaltungen 310 vorzugsweise eine Versorgungs-Entkoppelungsschaltung 503 mit galvanischer Trennung vorgesehen (s. Fig. 6) und der auf diese Weise zwischen der Gate-Treiber-Versorgungsspannungsquelle SV_{SUPPLY} und den Gate-Treiber-Spannungsversorgungsschaltungen 310 geschaltete und von diesen jeweils galvanisch entkoppelte Stromkreis als PELV-Versorgungsstromkreis PVSK ausgebildet.

Auf diese Weise kann selbst bei Versagen einer der beiden galvanischen Entkopplungen des PELV-Signalstromkreises PSSK oder einer der beiden galvanischen Entkopplungen des PELV-Versorgungsstromkreises PVSK weiterhin eine galvanische Entkopplung zwischen Leistungshalbleiter-Schaltung 206 und Steuerelektronik 210 bzw. Gate-Treiber-Versorgungsspannungsquelle SV_{SELV} aufrechterhalten werden, wobei Fehlerströme sicher über den PE-Schutzleiter abgeleitet werden. Auf diese Weise können zum Beispiel die Isolationen in den DC/DC-Wandlern DC1 - DC4 der Gate-Treiber-Spannungsversorgungen 310 und in den Gate-Treibern GT1 - GT4 als einfache Isolierungen ausgeführt werden, wodurch Kosten durch die Verwendbarkeit einfacherer elektronischer Bauteile reduziert werden können.

Der PELV-Signalstromkreis PSSK und der PELV-Versorgungsstromkreis PVSK können elektrisch miteinander verbunden sein, d.h. es kann sich um denselben PELV-Stromkreis handeln. Weiter kann die Gate-Treiber-Spannungsquelle SV_{SUPPLY}, wie im Ausführungsbeispiel in Fig. 6 der Fall, auch als Spannungsquelle für den Steuerstromkreis SSK bzw. die Steuerelektronik 210 dienen. In einem alternativen Ausführungsbeispiel kann für den Steuerstromkreis SSK bzw. die Steuerelektronik 210 auch eine gesonderte Spannungsquelle vorgesehen sein.

Das integrierte Leistungselektronik-Modul 300' des Leistungsteils 116' weist im Wesentlichen den gleichen Aufbau und die gleiche Funktionsweise auf wie das Leistungselektronik-Modul 300 des Leistungsteils 116. Die Unterschiede aufgrund des PELV-Signal- und -Versorgungsstromkreises werden nachfolgend anhand der Fig. 6 erläutert.

Das Leistungsteil 116' mit dem Leistungselektronik-Modul 300' bildet eine zur Vorrichtung 350 alternative Vorrichtung 350' zur Erzeugung eines Schweißstroms für das Lichtbogenschweißgerät 100 und stellt somit ein weiteres Ausführungsbeispiel der Vorrichtung zur Erzeugung eines Schweißstroms für ein Schweißgerät, insbesondere Lichtbogenschweißgerät, dar.

Fig. 6 zeigt einen möglichen Schaltplan des Leistungselektronik-Moduls 300' mit angeschlossener Signal-Entkoppelungsschaltung 502 und Versorgungs-Entkoppelungsschaltung 503 der Vorrichtung 350'.

Das Leistungselektronik-Modul 300' in Fig. 5 weist einen ähnlichen Aufbau und eine ähnliche Funktionsweise auf wie das Leistungselektronik-Modul 300 aus Fig. 4. Einander entsprechende Komponenten sind mit denselben Bezugszeichen versehen wie in Fig. 4 und es wird insoweit auf die Beschreibung von Fig. 4 verwiesen.

Das Leistungselektronik-Modul 300' unterscheidet sich dadurch vom Leistungselektronik-Modul 300, dass ein zusätzlicher PE-Anschluss (APE) zum Anschluss an den Schutzleiter PE der Schweißstromquelle 110 vorgesehen ist. Die Leitungen in der Gate-Treiber-Schaltung zum PE-Anschluss APE bzw. vom PE-Anschluss APE zum Schutzleiter PE der Schweißstromquelle 110 sind derart dimensioniert, um eine Schutzerdung des PELV-Signalstromkreises PSSK bzw. PELV-Versorgungsstromkreises PVSK bewirken zu können. Insbesondere sind diese Leitungen derart ausgelegt, um in einem Fehlerfall in der galvanischen Trennung in einem der DC/DC-Wandler DC1 - DC4 bzw. Gate-Treiber GT1 - GT4 den im Gate-Ansteuerstromkreis GSK fließenden Strömen entsprechende Fehlerströme, zum Beispiel Stoßströme von ca. 10 kA, zum PE-Anschluss APE tragen zu können, insbesondere zum Schutzleiter PE der Schweißstromquelle 110 ableiten zu können.

Zu diesem Zweck kann der PE-Anschluss APE zum Beispiel über die Verschraubung des Moduls in der Schweißstromquelle 110, zum Beispiel über das Gehäuse der Schweißstromquelle 110, mit dem Schutzleiter PE der Schweißstromquelle 110 verbunden sein.

Die Signal-Entkoppelungsschaltung 502 umfasst einen Signalisolator 508 mit galvanischer Trennung. Der Signalisolator 508 ermöglicht eine Signalübertragung mit galvanischer Trennung von Schaltsignalen der Steuerelektronik 210 zu den Schaltsignaleingängen T1 - T4.

Die Versorgungs-Entkoppelungsschaltung 503 im vorliegenden Ausführungsbeispiel einen DC/DC-Wandler 506 mit galvanischer Trennung, um auch die Spannungsversorgung über einen zwischengeschalteten PELV-Versorgungsstromkreis PVSK (Potentiale U⁺_{PELV}, U⁰_{PELV}) zu bewirken. Der DC/DC-Wandler 506 wird durch eine Spannungsversorgung (Potentiale U⁺_{SUPPLY}, U⁰_{SUPPLY}) gespeist. Bei dieser Spannungsversorgung kann es sich um die Spannungsversorgung des SELV-Stromkreises (Potentiale U⁺_{SELV}, U⁰_{SELV}) handeln, mit dem die Steuerelektronik 210 betrieben wird, es ist aber auch denkbar, dass eine hiervon separate Spannungsversorgung vorgesehen ist.

Durch die Kombination eines integrierten Leistungselektronik-Moduls 300' mit Gate-Treiber-Schaltung 208 und Leistungshalbleiter-Schaltung 206 sowie einem PELV-Signalstromkreis PSSK bzw. PELV-Versorgungsstromkreis PVSK zwischen einerseits dem Steuerstromkreis SSK der Steuerelektronik 210 bzw. dem Versorgungstromkreis VSK der Gate-Treiber-Stromquelle SV_{SUPPLY} und andererseits dem Gate-Ansteuerstromkreis GSK auf Seiten der Leistungshalbleiter-Schaltung 206 wird eine hohe Betriebssicherheit erreicht, die auch im Versagensfall und beim Einsatz in Betriebsumgebungen mit hohen Verschmutzungsgraden gewährleistet bleibt. Gleichzeitig erlaubt das integrierte Leistungselektronik-Modul 300' schnelle Schaltzeiten mit geringen Störeinflüssen und damit geringere Verluste.

### Bezugszeichenliste:

- 100: Lichtbogenschweißgerät
- 110: Schweißstromquelle
- 112: Netzanschluss
- 114: Schweißstromausgang
- 114a: erster Anschluss des Schweißstromausgangs
- 114b: zweiter Anschluss des Schweißstromausgangs
- 116, 116': Leistungsteil
- 118: Steuereinrichtung
- 120: Nutzerschnittstelle
- 140: Schweißbrenner
- 142: Brennerteil
- 144: Elektrode
- 146: Anschlusskabel
- 180: Werkstück
- 182: Werkstückleitung
- 184: Lichtbogenstrecke
- 202: Gleichrichter
- 204: Zwischenkreis
- 206: Leistungshalbleiter-Schaltung
- 208: Gate-Treiber-Schaltung
- 210: Steuerelektronik
- 211: Pulserzeugung
- 212: Transformator
- 214: Ausgangs-Gleichrichter
- 216: Ausgangsdrossel
- 300, 300': integriertes Leistungselektronik-Modul
- 302: Leiterplatte
- 304: Kunststoffrahmen
- 306: Vergussmasse
- 310: Gate-Treiber-Spannungsversorgung
- 350, 350': Vorrichtung
- 502: Signal-Entkoppelungsschaltung
- 503: Versorgungs-Entkoppelungsschaltung
- 506: DC/DC-Wandler
- 508: Signalisolator
- APE: PE-Anschluss
- D: Drain-Anschluss
- DC1, DC2, DC3, DC4: DC/DC-Wandler mit galvanischer Trennung
- G: Gate-Anschluss
- GSK: Gate-Ansteuerstromkreis
- GT1, GT2, GT3, GT4: Gate-Treiber mit galvanischer Trennung
- KS: Kelvin-Source-Anschluss
- L_{A}: Ansteuerleitung
- L_{AM}: Miller-Ansteuerleitung
- L_{R}: Ansteuerrückleitung
- LSK: Leistungsstromkreis
- MC: Miller-Clamp-Anschluss
- PE: Schutzleiter
- PSSK: PELV-Steuerstromkreis
- PVSK: PELV-Versorgungsstromkreis
- S: Source-Anschluss
- S1, S2, S3, S4: Leistungshalbleiter-Schaltelement
- SSK: Steuerstromkreis
- SVE: Spannungsversorgungseingang
- SV_{SUPPLY}: Gate-Treiber-Spannungsquelle
- T1, T2, T3, T4: Steuersignaleingang
- TA1, TA2, TA3, TA4: Treiberausgang

## Patentansprüche

1. Vorrichtung (350, 350') zur Erzeugung eines Schweißstroms für ein Schweißgerät (100), insbesondere Lichtbogenschweißgerät,
- mit einer Leistungshalbleiter-Schaltung (206) umfassend ein oder mehrere Leistungshalbleiter-Schaltelemente (S1, S2, S3, S4) und
- mit einer Gate-Treiber-Schaltung (208), die ein oder mehrere Steuersignaleingänge (T1, T2, T3, T4) zum Empfang von elektrischen Steuersignalen und ein oder mehrere Treiberausgänge (TA1, TA2, TA3, TA4) zum elektrischen Ansteuern der ein oder mehreren Leistungshalbleiter-Schaltelemente (S1, S2, S3, S4) aufweist und dazu eingerichtet ist, die Leistungshalbleiter-Schaltelemente (S1, S2, S3, S4) abhängig von über die ein oder mehreren Steuersignaleingänge (T1, T2, T3, T4) empfangenen elektrischen Steuersignalen elektrisch anzusteuern,
- wobei die Gate-Treiber-Schaltung (208) so ausgebildet ist, dass die ein oder mehreren Steuersignaleingänge (T1, T2, T3, T4) von den ein oder mehreren Treiberausgängen (TA1, TA2, TA3, TA4) galvanisch getrennt sind,
**dadurch gekennzeichnet,**
- **dass** die Vorrichtung (350, 350') ein integriertes Leistungselektronik-Modul (300, 300') aufweist, das sowohl die Leistungshalbleiter-Schaltung (206) als auch die Gate-Treiber-Schaltung (208) umfasst.

2. Vorrichtung nach Anspruch 1,
**dadurch gekennzeichnet, dass** das Leistungselektronik-Modul (300, 300') eine Leiterplatte (302) aufweist, auf der sowohl die Leistungshalbleiter-Schaltung (206) als auch die Gate-Treiber-Schaltung (208) angeordnet sind.

3. Vorrichtung nach Anspruch 1 oder 2,
**dadurch gekennzeichnet, dass** die Leistungshalbleiter-Schaltung (206) und die Gate-Treiber-Schaltung (208) in dem Leistungselektronik-Modul (300, 300') mit einer Vergussmasse (306) vergossen sind.

4. Vorrichtung nach einem der Ansprüche 1 bis 3,
**dadurch gekennzeichnet, dass** mindestens einer der ein oder mehreren Leistungshalbleiter-Schaltelemente (S1, S2, S3, S4) als Wide-Bandgap-Leistungshalbleiter-Schaltelement ausgebildet ist.

5. Vorrichtung nach einem der Ansprüche 1 bis 4,
**dadurch gekennzeichnet, dass** die Länge einer elektrischen Ansteuerleitung (L_{A}) von einem der ein oder mehreren Treiberausgänge (TA1, TA2, TA3, TA4) der Gate-Treiber-Schaltung (208) zu einem zugehörigen der ein oder mehreren Leitungshalbleiter-Schaltelemente (S1, S2, S3, S4) maximal 200 mm beträgt.

6. Vorrichtung nach einem der Ansprüche 1 bis 5,
**dadurch gekennzeichnet, dass** die Gate-Treiber-Schaltung (208) ein oder mehrere Gate-Treiber (GT1, GT2, GT3, GT4) aufweist, die jeweils dazu eingerichtet sind, die Ansteuerung von mindestens einem der ein oder mehreren Leistungshalbleiter-Schaltelemente (S1, S2, S3, S4) über einen der Treiberausgänge (TA1, TA2, TA3, TA4) abhängig von über mindestens einen der ein oder mehreren Steuersignaleingänge (T1, T2, T3, T4) erhaltenen Steuersignalen zu bewirken.

7. Vorrichtung nach Anspruch 6,
**dadurch gekennzeichnet, dass** die ein oder mehreren Gate-Treiber (GT1, GT2, GT3, GT4) einen jeweiligen Signalisolator zur galvanisch getrennten Übertragung von über einen jeweiligen Steuersignaleingang (T1, T2, T3, T4) erhaltenen Steuersignalen aufweisen und dazu eingerichtet sind, die zur Ansteuerung eines jeweiligen der Leistungshalbleiter-Schaltelemente (S1, S2, S3, S4) verwendete elektrische Leistung zumindest teilweise über eine vom Signalisolator separate Gate-Treiber-Spannungsversorgungsschaltung (310) zu erhalten.

8. Vorrichtung nach einem der Ansprüche 1 bis 7,
**dadurch gekennzeichnet, dass** die Vorrichtung (350, 350') ein oder mehrere Gate-Treiber-Spannungsversorgungsschaltungen (310) aufweist, wobei vorzugsweise das integrierte Leistungselektronik-Modul (300, 300') die ein oder mehreren Gate-Treiber-Spannungsversorgungsschaltungen (310) umfasst.

9. Vorrichtung nach einem der Ansprüche 1 bis 8,
**dadurch gekennzeichnet, dass** für mindestens einen der ein oder mehreren Treiberausgänge (TA1, TA2, TA3, TA4) ein zugehöriger Miller-Clamp-Anschluss (MC) vorgesehen ist, der mit dem Gate-Anschluss (G) des zugehörigen Leistungshalbleiter-Schaltungselements (S1, S2, S3, S4) verbunden ist.

10. Vorrichtung nach einem der Ansprüche 1 bis 9,
**dadurch gekennzeichnet, dass** die ein oder mehreren Steuersignaleingänge (T1, T2, T3, T4) der Gate-Treiber-Schaltung (208) mit einem PELV-Signalstromkreis (PSSK) verbunden sind.

11. Vorrichtung nach einem der Ansprüche 8 bis 10,
**dadurch gekennzeichnet, dass** die ein oder mehreren Gate-Treiber-Spannungsversorgungsschaltungen (310) mit einem PELV-Versorgungsstromkreis (PVSK) verbunden sind.

12. Vorrichtung nach Anspruch 10 oder 11,
**dadurch gekennzeichnet, dass** der PELV-Signalstromkreis (PSSK) über eine Signal-Entkoppelungsschaltung (502) mit einem Steuerstromkreis (SSK) gekoppelt ist, so dass Steuersignale von dem Steuerstromkreis (SSK) auf den PELV-Signalstromkreis (PSSK) übertragen werden können, wobei die Signal-Entkoppelungsschaltung (502) den PELV-Signalstromkreis (PSSK) und den Steuerstromkreis (SSK) voneinander galvanisch trennt, und/oder dass der PELV-Versorgungsstromkreis (PVSK) über eine Versorgungs-Entkoppelungsschaltung (503) mit einer Gate-Treiber-Spannungsquelle (SV_{SUPPLY}) gekoppelt ist, wobei die Versorgungs-Entkoppelungsschaltung (503) den PELV-Versorgungsstromkreis (PVSK) und die Gate-Treiber-Spannungsquelle (SV_{SUPPLY}) voneinander galvanisch trennt.

13. Vorrichtung nach Anspruch 12,
**dadurch gekennzeichnet, dass** das integrierte Leistungselektronik-Modul (300, 300') die Signal-Entkoppelungsschaltung (502) und/oder die Versorgungs-Entkoppelungsschaltung (503) umfasst.

14. Vorrichtung nach einem der Ansprüche 1 bis 13,
**dadurch gekennzeichnet, dass** eine Pulserzeugung (211) vorgesehen ist, wobei die Pulserzeugung (211) dazu eingerichtet ist, ein Schalten der Leistungshalbleiter-Schaltelemente (S1, S2, S3, S4) mittels der Gate-Treiber-Schaltung (208) mit einer Schaltfrequenz im Bereich von 20 bis 500 kHz zu bewirken.

15. Schweißgerät (100), insbesondere Lichtbogenschweißgerät, aufweisend eine Vorrichtung (350, 350') nach einem der Ansprüche 1 bis 14.
